# EUROPEAN PATENT APPLICATION

(11) **EP 2 787 802 A1**
(43) Date of publication of application: **08.10.2014**
(21) Application number: 12853549.9
(22) Date of filing: 16.11.2012
(51) Int. Cl.: H05K 7/20, H05K 7/18

(54) **ELECTRONIC BOARD CONTAINING DEVICE AND ELECTRONIC APPARATUS**

(30) Priority: 01.12.2011 JP 2011263753
(71) Applicant: NEC Corporation, Tokyo 108-8001 (JP)
(72) Inventor: YOSHIKAWA, Minoru, Tokyo 108-8001 (JP); SAKAMOTO, Hitoshi, Tokyo 108-8001 (JP); CHIBA, Masaki, Tokyo 108-8001 (JP); INABA, Kenichi, Tokyo 108-8001 (JP); MATSUNAGA, Arihiro, Tokyo 108-8001 (JP)
(74) Representative: Vossius & Partner
(86) International application number: PCT/JP2012/080402
(87) International publication number: WO 2013/080897

(57) **Abstract**

An electronic substrate 200A mounts a heater element 220. A chassis 300A houses an electronic substrate 200 in an airtight manner. A cooling unit 400 cools the electronic substrate 200. The cooling unit 400 includes a heat receiving part 410 and a heat radiation part 420. The heat receiving part 410 receives heat from the electronic substrate 200. The heat radiation part 420 is connected with the heat receiving part 410, and radiates heat from the electronic substrate 200 which has received by the heat receiving part 410. Further, the heat receiving part 410 is provided in the chassis 300A in an airtight manner, and the heat radiation part 420 is provided outside the chassis 300. As a result, efficient cooling is possible, and moreover, maintenance replacement work can be performed for each piece of electronic substrate housing equipment individually.

## Description

### Technical Field

The present invention relates to electronic substrate housing equipment and electronic apparatus, and, more particularly, to electronic substrate housing equipment and electronic apparatus that have a structure to radiate heat of an electronic substrate on which heater elements are mounted.

### Background Art

In recent years, in electronic apparatus such as communication equipment and a computer, increase in performance and functional sophistication, such as carrying out a great deal of operations at one time at high speed, is advancing rapidly. Along with this, in a central processing unit (Central Processing Unit: CPU), an integrated circuit (IC) and the like, in particular, among components mounted onto electronic apparatus (for example, ICT (Information and Communication Technology) apparatus), there is a tendency toward increase in an amount of heat generation.

While there is increase in a heat generation amount of a CPU and an IC thus, in recent years, there is increasing demands for installing electronic apparatus such as communication apparatus and a computer in not only an exclusive computer room for installing a computer but also various environments.

Regarding electronic apparatus which meets such requests, there is known a technology to cool the apparatus efficiently by making it sealed tight (patent document 1, for example).

In the technology described in patent document 1, an inner space which is substantially sealed tight is provided in a network cabinet, and a plurality of stacked electronic modules (a server having units of the height of 1 U (1.75 inches), for example) are housed in the inner space. A fan is provided in the chassis of each electronic module. Further, a vapor heat exchanger is provided under the inner space in the network cabinet. In the network cabinet, air cooled by the vapor heat exchanger passes through an electronic module via an air intake duct. The air which has passed the electronic module goes further through an air intake duct and a second ventilation route, and is transported to the vapor heat exchanger.

Patent document 1: Japanese Patent Publication No. 4212625 (paragraphs 0049-0051 and Fig. 1, in particular)

### Disclosure of the Invention

### Problems to be Solved by the Invention

In the technology described in patent document 1, an inner space which accommodates stacked electronic modules is sealed substantially, and air cooled by a vapor heat exchanger is made to be circulated through in the network cabinet. However, because it is constituted such that each electronic module is cooled by sending this cooled air to each electronic module, an electronic module itself is not sealed. For this reason, in the technology described in patent document 1, there is a problem that trash and dust flow into an electronic module when a certain electronic module is replaced at the time of a maintenance operation and at the time of a replacement operation, for example, becoming the cause of a failure. In other words, when a plurality of pieces of electronic substrate housing equipment (electronic module) are tried to be cooled efficiently as is the case with the technology described in patent document 1, there is a problem that maintenance replacement work cannot be performed for each individual piece of electronic substrate housing equipment.

The present invention has been made in view of such circumstances, and an object of the present invention is to provide electronic substrate housing equipment and electronic apparatus which settle the problem that maintenance replacement work cannot be performed for each individual piece of electronic substrate housing equipment if it is tried to cool electronic substrate housing equipment efficiently.

### Means for Solving the Problems

Electronic substrate housing equipment of the present invention has: an electronic substrate to mount a heater element; a chassis to house the electronic substrate in an airtight manner; a cooling unit to cool the electronic substrate; and the cooling unit including: a heat receiving part to receive heat from the electronic substrate; a heat radiation part, connected with the heat receiving part, to radiate heat received by the heat receiving part; and the heat receiving part being provided in the chassis in an airtight manner, and the heat radiation part being provided outside the chassis.

Electronic apparatus of the present invention has: electronic substrate housing equipment and a rack to house the electronic substrate housing equipment, wherein the electronic substrate housing equipment includes: an electronic substrate to mount a heater element; a chassis to house the electronic substrate in an airtight manner; and a cooling unit, wherein the cooling unit includes: a heat receiving part to receive heat from the electronic substrate; and a heat radiation part, connected with the heat receiving part, to radiate heat received by the heat receiving part; and wherein the heat receiving part is provided in the chassis in an airtight manner, and the heat radiation part is provided outside the chassis.

### Advantage of the Invention

According to electronic substrate housing equipment and electronic apparatus according to the present invention, efficient cooling is possible, and moreover, maintenance replacement work can be performed for each electronic substrate housing equipment individually.

### Brief Description of the Drawings

Fig. 1 is a side face perspective view showing a structure of electronic substrate housing equipment in a first exemplary embodiment of the present invention seen through from a side.
Fig. 2 is a surface perspective view seen from cutting plane A-A of Fig. 1.
Fig. 3 is a side face perspective view seen from cutting plane B-B of Fig. 2.
Fig. 4 is a side face perspective view seen from cutting plane C-C of Fig. 2.
Fig. 5 is a perspective view showing a structure of a cooling unit.
Fig. 6 is a perspective pattern diagram in which an internal configuration of a heat receiving part and a heat radiation part are seen through schematically.
Fig. 7 is a side face perspective view showing a structure of electronic apparatus in the first exemplary embodiment of the present invention seen through from a side.
Fig. 8 is a side face perspective view showing a structure of electronic apparatus in the first exemplary embodiment of the present invention seen through from a side.
Fig. 9 is a sectional view showing a structure of electronic substrate housing equipment in a second exemplary embodiment of the present invention seen through from a side.
Fig. 10 is a side face perspective view showing a structure of electronic substrate housing equipment in a third exemplary embodiment of the present invention seen through from a side.
Fig. 11 is a surface perspective view seen from cutting plane D-D of Fig. 10.
Fig. 12 is a diagram showing view E of Fig. 10.
Fig. 13 is a diagram showing view F of Fig. 10.
Fig. 14 is a side face perspective view showing a structure of electronic apparatus in the third exemplary embodiment of the present invention seen through from a side.
Fig. 15 is a side face perspective view showing a structure of electronic apparatus in a fourth exemplary embodiment of the present invention seen through from a side.
Fig. 16 is a diagram showing view G of Fig. 15.
Fig. 17 is a diagram showing view H of Fig. 15.
Fig. 18 is a surface perspective view showing a structure of electronic substrate housing equipment in the fourth exemplary embodiment of the present invention seen through from the upper surface side.
Fig. 19 is a diagram showing view J of Fig. 18.
Fig. 20 is a diagram showing view K of Fig. 18.
Fig. 21 is a side face perspective view showing a structure of electronic substrate housing equipment in a sixth exemplary embodiment of the present invention seen through from a side.
Fig. 22 is a surface perspective view seen from cutting plane L-L of Fig. 21.
Fig. 23 is a side face perspective view seen from cutting plane M-M of Fig. 22.
Fig. 24 is a side face perspective view seen from cutting plane N-N of Fig. 22.
Fig. 25 is a diagram that quotes and shows a structure of electronic substrate housing equipment in the first exemplary embodiment of the present invention in order to describe an effect of electronic substrate housing equipment in the sixth exemplary embodiment of the present invention.
Fig. 26 is a surface perspective view showing a structure of electronic substrate housing equipment in a seventh exemplary embodiment of the present invention seen through from the upper surface side.
Fig. 27 is a surface perspective view seen from cutting plane P-P of Fig. 26.
Fig. 28 is a surface perspective view seen from cutting plane Q-Q of Fig. 26.
Fig. 29 is a side face perspective view showing a structure of electronic substrate housing equipment in an eighth exemplary embodiment of the present invention seen through from a side.
Fig. 30 is a surface perspective view seen from cutting plane R-R of Fig. 29.
Fig. 31 is a side face perspective view seen from cutting plane S-S of Fig. 30.
Fig. 32 is a side face perspective view seen from cutting plane T-T of Fig. 30.
Fig. 33 is a sectional view showing a section when being cut by cutting plane U-U of Fig. 30.
Fig. 34 is a side face perspective view showing a structure of electronic substrate housing equipment in a ninth exemplary embodiment of the present invention seen through from a side.
Fig. 35 is a surface perspective view seen from cutting plane X-X of Fig. 34.

### Description of Embodiments

### <First exemplary embodiment>

The configuration of electronic substrate housing equipment 100 and electronic apparatus 1000 in the first exemplary embodiment of the present invention will be described based on a drawing. A configuration of the electronic substrate housing equipment 100 is described first, and a configuration of the electronic apparatus 1000 that provides accommodation for the electronic substrate housing equipment 100 is described after that.

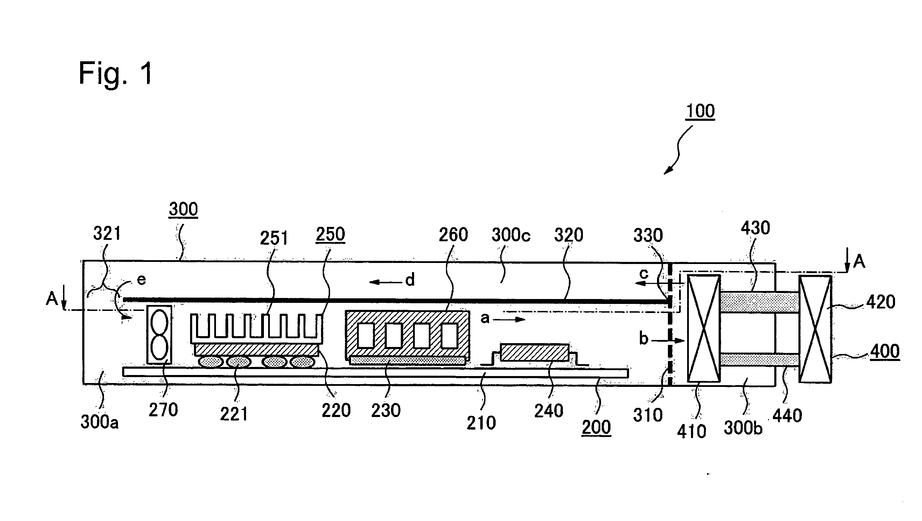

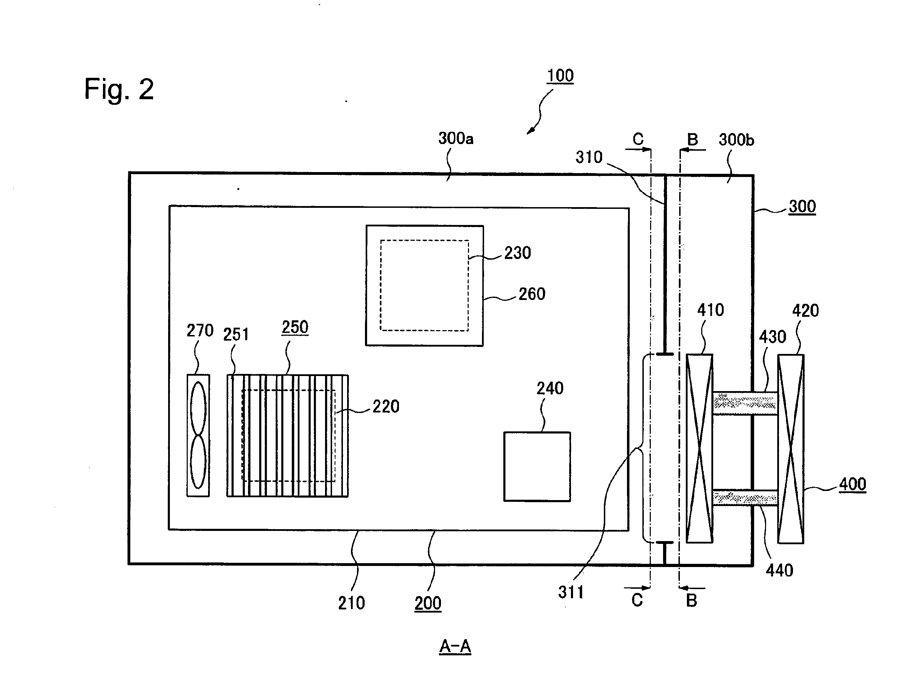

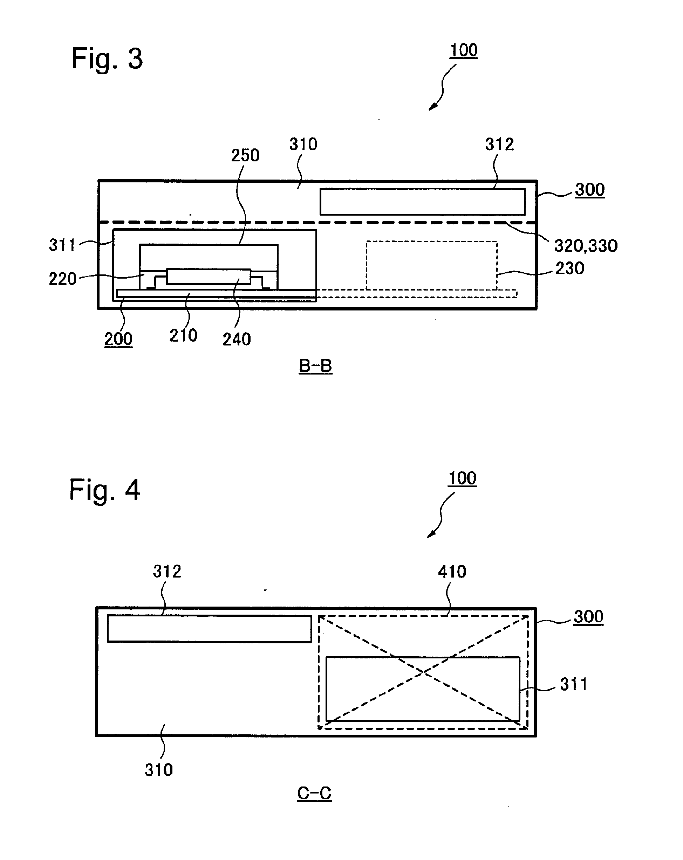

Fig. 1 is a side face perspective view showing a structure of the electronic substrate housing equipment 100 in the first exemplary embodiment of the present invention seen through from a side. Fig. 2 is a surface perspective view seen from cutting plane A-A of Fig. 1. Meanwhile, in Fig. 2, as it will be described in detail later, both of a steam pipe 430 and a liquid pipe 440 are being indicated for convenience of explanation, although, in reality, the liquid pipe 440 hides behind the steam pipe 430. Fig. 3 is a side face perspective view seen from cutting plane B-B of Fig. 2. Fig. 4 is a side face perspective view seen from cutting plane C-C of Fig. 2.

As shown in Fig. 1 and Fig. 2, the electronic substrate housing equipment 100 is constituted including an electronic substrate 200, a chassis 300 and a cooling unit 400. The electronic substrate 200, the chassis 300 and the cooling unit 400 will be described in detail based on a drawing below.

First, a configuration of the electronic substrate 200 will be described. The electronic substrate 200 is constituted including a substrate material 210, a plurality of electronic components 220-240, a heat receiving part 250 for heater elements, a heat receiving part 260 for electronic components and a fan 270 for an electronic substrate.

The substrate material 210 is a printed wiring board formed into a tabular form, for example. As a material of a substrate material, a flame retardancy material of glass epoxy is used, for example.

The plurality of electronic components 220-240 are a heater element such as CPU and IC, a coil, a resistor, a capacitor and the like. A heater element is a device which emits high heat when it operates. A heater element is included in the plurality of electronic components 220-240 at least. Here, it is supposed that the electronic component 220 is a heater element, and the heater element 220 will be treated in a manner being distinguished from the other electronic components 230 and 240 in the following description.

The heater element 220 is attached to the substrate material 210 via a solder 221. That is, the electronic substrate 200 mounts at least the heater element 220. Meanwhile, here, although it has been explained that the heater element 220 is attached to the substrate material 210 by the solder 221, the heater element 220 may be attached to the substrate material 210 using a socket (not shown) or the like, for example.

As shown in Fig. 1 and Fig. 2, the heater-element heat receiving part 250 is attached onto the heater element 220. This heater-element heat receiving part 250 receives generated heat of the heater element 220, and radiates the received heat via a fin 251 in the side of the heater-element heat receiving part.

As shown in Fig. 1 and Fig. 2, a plurality of pieces of tabular heater-element-heat-receiving-part-side fin 251 are formed onto the upper surface of the heater-element heat receiving part 250. The heater-element-heat-receiving-part-side fin 251 lowers temperature of the heater element 220 by radiating generated heat of the heater element 220.

Meanwhile, here, it has been explained that the shape of the heater-element-heat-receiving-part-side fin 251 is made to be of a plate shape. However, the heater-element-heat-receiving-part-side fin 251 has only to have a wide surface area in order to fulfil the function to radiate heat, and thus it may be formed into a pinholder shape, a stick shape or a bellows shape, for example. The heater-element heat receiving part 250 is formed of a thermal conductivity member such as aluminum, copper and their alloys, and, more preferably, formed of a material having a small thermal resistance.

The electronic components 230 and 240 are attached on the substrate material 210 by solder (not shown), a socket (not shown) or the like. Meanwhile, in Fig. 1 and Fig. 2, an example in which the electronic-component heat receiving part 260 is also provided on the electronic component 230 is being indicated.

As shown in Fig. 1 and Fig. 2, the electronic-substrate fan 270 is provided on the substrate material 210. The electronic-substrate fan 270 cools the electronic components 220-240 (in particular, the heater element 220 among these) within the chassis 300. The electronic-substrate fan 270 is provided in a manner facing the heater element 220. The electronic-substrate fan 270 promotes circulation of air between an electronic substrate reception chamber 300a, a heat receiving part reception chamber 300b and an air guiding chamber 300c that will be mentioned later.

As above, the structure of the electronic substrate 200 has been described.

Next, a structure of the chassis 300 will be described. As shown in Fig. 1, the chassis 300 houses the electronic substrate 200 in an airtight manner.

As shown in Fig. 1, the chassis 300 is divided by an intake/exhaust air division plate 310 and a partition plate 320 into three rooms. That is, the chassis 300 has the electronic substrate reception chamber 300a, the heat receiving part reception chamber 300b and the air guiding chamber 300c. Meanwhile, because the intake/exhaust air division plate 310 has two openings 311 and 312 as will be mentioned later, the intake/exhaust air division plate 310 is indicated by a dotted line in Fig. 1.

As shown in Fig. 1, the intake/exhaust air division plate 310 is provided between the electronic substrate reception chamber 300a and the heat receiving part reception chamber 300b, and it separates the electronic substrate reception chamber 300a and the heat receiving part reception chamber 300b. Similarly, the intake/exhaust air division plate 310 is provided between the heat receiving part reception chamber 300b and the air guiding chamber 300c, and it separates the heat receiving part reception chamber 300b and the air guiding chamber 300c. The partition plate 320 is provided between the electronic substrate reception chamber 300a and the air guiding chamber 300c, and it separates the electronic substrate reception chamber 300a and the air guiding chamber 300c.

Meanwhile, at a joint 330 of the intake/exhaust air division plate 310 and the partition plate 320, the substrate reception chamber 300a, the heat receiving part reception chamber 300b and the air guiding chamber 300c neighbor each other.

Here, the substrate reception chamber 300a houses the electronic substrate 200. The heat receiving part reception chamber 300b houses a heat receiving part 410 included in the cooling unit 400 mentioned later. On the other hand, the air guiding chamber 300c houses none of the electronic substrate 200 and the heat receiving part 410.

Also, the air guiding chamber 300c forms a flow path of air between the heat receiving part reception chamber 300b and the electronic substrate reception chamber 300a. More specifically, the air guiding chamber 300c guides air which flows out from the heat receiving part reception chamber 300b into the electronic substrate reception chamber 300a.

As mentioned above, two openings 311 and 312 are provided in the intake/exhaust air division plate 310. That is, as shown in Figs. 2-4, the opening 311 for warm air exhaust and the opening 312 for cold air supply are formed into the intake/exhaust air division plate 310.

The warm air exhaust opening 311 is formed in a face that has contact with the electronic substrate reception chamber 300a separated by the partition plate 320 within the intake/exhaust air division plate 310. The warm air exhaust opening 311 links between the electronic substrate reception chamber 300a and the heat receiving part reception chamber 300b. Meanwhile, the warm air exhaust opening 311 corresponds to a first opening of the present invention.

At that time, as shown in Fig. 2 and Fig. 3, the heater element 220 and the heater-element heat receiving part 250 face the warm air exhaust opening 311. As a result, air containing heat of the heater element 220 in particular flows into the heat receiving part reception chamber 300b through the warm air exhaust opening 311.

The heater element 220 and the heater-element heat receiving part 250 are arranged between the electronic-substrate fan 270 and the warm air exhaust opening 311. As a result, generated heat of the heater element 220 is cooled by the electronic-substrate fan 270 directly. At the same time, heat received by the heater-element heat receiving part 250 among generated heat of the heater element 220 is also cooled by the electronic-substrate fan 270 directly.

Air blown by the electronic-substrate fan 270 will contain heat of the electronic substrate 200 mainly including heat of the heater element 220, become warm air, and then flow into the heat receiving part reception chamber 300b through the warm air exhaust opening 311.

The cold air supply opening 312 is formed in a face that has contact with the air guiding chamber 300c separated by the partition plate 320 within the intake/exhaust air division plate 310. The cold air supply opening 312 links between the heat receiving part reception chamber 300b and the air guiding chamber 300c. Meanwhile, the cold air supply opening 312 corresponds to a second opening of the present invention.

As above, the warm air exhaust opening 311 and the cold air supply opening 312 are formed into the intake/exhaust air division plate 310 separately. As a result, it is possible to prevent warm air which flows into the heat receiving part reception chamber 300b from the electronic substrate reception chamber 300a and cold air which flows into the air guiding chamber 300c from the heat receiving part reception chamber 300b from mixing with each other.

As shown in Fig. 1, a communication hole 321 is provided in the partition plate 320 installed between the electronic substrate reception chamber 300a and the air guiding chamber 300c. This communication hole 321 links between the electronic substrate reception chamber 300a and the air guiding chamber 300c. Accordingly, air in the electronic substrate reception chamber 300a and air in the air guiding chamber 300c can move back and forth via the communication hole 321. Meanwhile, the communication hole 321 corresponds to a third opening of the present invention.

As above, the structure of chassis 300 has been described.

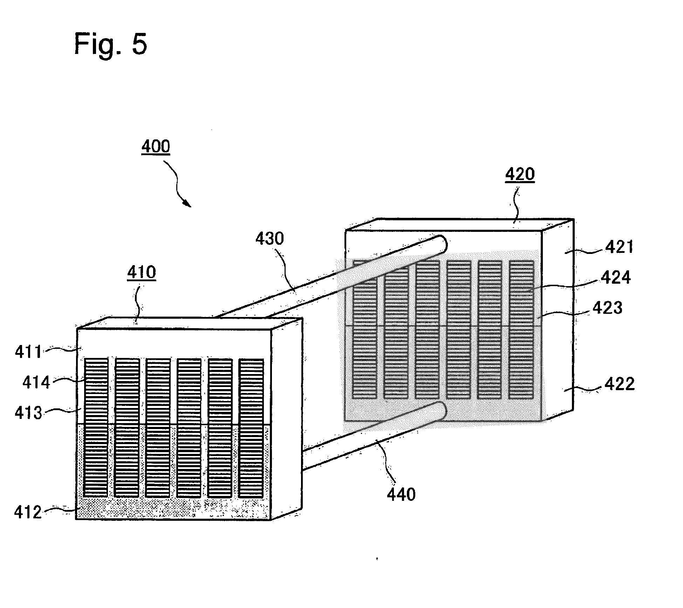

Next, a structure of the cooling unit 400 will be described. Fig. 5 is a perspective view showing a structure of the cooling unit 400. As shown in Fig. 1, Fig. 2 and Fig. 5, the cooling unit 400 has the heat receiving part 410, a heat radiation part 420, the steam pipe 430 and the liquid pipe 440. Meanwhile, a heat receiving part and a first heat receiving part of the present invention correspond to the heat receiving part 410.

As shown in Fig. 5, the heat receiving part 410 and the heat radiation part 420 are connected by the steam pipe 430 and the liquid pipe 440. Meanwhile, although the liquid pipe 440 hides behind the steam pipe 430 in nature, both of the steam pipe 430 and the liquid pipe 440 are being indicated in Fig. 2 for convenience of explanation.

The cooling unit 400 has a refrigerant (Coolant: hereinafter, referred to as COO) which circulates between the heat receiving part 410 and the heat radiation part 420. That is, there is a hollow provided inside the heat receiving part 410 and the heat radiation part 420.

Refrigerant COO is enclosed in a closed space formed by the heat receiving part 410, the heat radiation part 420, the steam pipe 430 and the liquid pipe 440 in the state made airtight. This refrigerant COO circulates between the heat receiving part 410 and the heat radiation part 420 via the steam pipe 430 and the liquid pipe 440 in the state made airtight. A refrigerant is constituted of high polymer materials, for example, and has a characteristic of being vaporized when it becomes hot, and being liquefied when it becomes cold.

As shown in Fig. 1, Fig. 2 and Fig. 5, the heat receiving part 410 is being housed in the heat receiving part reception chamber 300b of the chassis 300. At that time, the heat receiving part 410 is provided in the chassis 300 in an airtight manner.

The heat receiving part 410 is connected to the heat radiation part 420 by the steam pipe 430 and the liquid pipe 440. The heat receiving part 410 receives heat of the electronic substrate 200 via air blown by the electronic-substrate fan 270.

Then, the heat receiving part 410 transfers the received heat of the electronic substrate 200 to the heat radiation part 420 via the steam pipe 430 using refrigerant COO. That is, when described more specifically, blown air which has been made to be hotter by heat of the electronic substrate 200, mainly by heat of the heater element 220, flows into the heat receiving part reception chamber 300b via the warm air exhaust opening 311.

The heat receiving part 410 receives heat of the electronic substrate 200 that flows into the heat receiving part reception chamber 300b via blown air. Then, the heat receiving part 410 transfers heat of the electronic substrate 200 that has been received to the heat radiation part 420 using refrigerant COO via the steam pipe 430. As a result, heat of the electronic substrate 200 is transferred to the heat radiation part 420.

The heat receiving part 410 is provided in a manner facing the warm air exhaust opening 311 as shown in Fig. 2 and Fig. 4. As a result, the heat receiving part 410 can receive heat of the electronic substrate 200 flowing in from the warm air exhaust opening 311 efficiently.

As shown in Fig. 1, Fig. 2 and Fig. 5, the heat radiation part 420 is connected by the steam pipe 430 and the liquid pipe 440 to the heat receiving part 410. The heat radiation part 420 receives heat of the electronic substrate 200 that has been received by the heat receiving part 410, and radiates the heat. That is, the heat radiation part 420 receives heat of the electronic substrate 200 from the heat receiving part 410 via refrigerant COO.

Then, the heat radiation part 420 radiates heat of the electronic substrate 200 that has been received to outside air. Here, the heat receiving part 410 is sealed in the chassis 300. In contrast, the heat radiation part 420 is provided outside the chassis 300. Accordingly, compared with a case when the heat radiation part 420 is installed in the chassis 300, there are no cases that heat released by the heat radiation part 420 is filled in the heat receiving part reception chamber 300b, and thus heat of the electronic substrate 200 can be radiated to outside air efficiently

As shown in Fig. 1, Fig. 2 and Fig. 5, the steam pipe 430 connects the heat receiving part 410 and the heat radiation part 420. Similarly, the liquid pipe 440 connects the heat receiving part 410 and the heat radiation part 420.

The steam pipe 430 and the liquid pipe 440 are used for making refrigerant COO circulate between the heat receiving part 410 and the heat radiation part 420. That is, the steam pipe 430 transports refrigerant COO vaporized by the heat receiving part 410 from the heat receiving part 410 to the heat radiation part 420. Conversely, the liquid pipe 440 transports refrigerant COO condensed and liquefied by the heat radiation part 420 from the heat radiation part 420 to the heat receiving part 410.

Meanwhile, in the vertical direction, the steam pipe 430 is arranged in a position higher than the liquid pipe 440. In Fig. 2, for convenience, in spite of the positional relationship between the steam pipe 430 and the liquid pipe 440 in the vertical direction, they are indicated in parallel with each other.

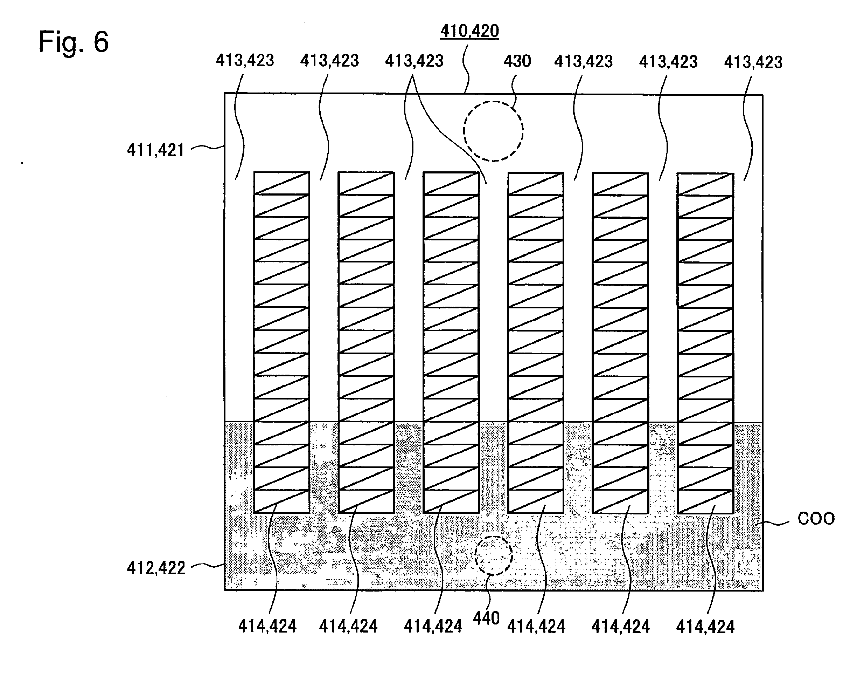

Next, an internal configuration of the heat receiving part 410 and the heat radiation part 420 will be described in detail based on a drawing. Fig. 6 is a schematic perspective diagram indicating an internal configuration of the heat receiving part 410 and the heat radiation part 420 in a schematically penetrated manner. Meanwhile, the basic structures of the heat receiving part 410 and the heat radiation part 420 are identical.

As shown in Fig. 5 and Fig. 6, for example, the heat receiving part 410 and the heat radiation part 420 are formed into a flat plate shape. As shown in Fig. 6, the heat receiving part 410 and the heat radiation part 420 have a hollow inside, and store refrigerant COO.

As shown in Fig. 5 and Fig. 6, the heat receiving part 410 is configured including an upper tank part 411, a lower tank part 412, a plurality of pieces of connecting pipe part 413 and a plurality of pieces of fin part 414 for the heat receiving part. Similarly, the heat radiation part 420 is configured including an upper tank part 421, a lower tank part 422, a plurality of pieces of connecting pipe part 423 and a plurality pieces of fin part 424 for the heat radiation part. In the vertical direction, the upper tank parts 411 and 421 are arranged in positions higher than the lower tank parts 412 and 422.

The connecting pipe part 413 of the heat receiving part 410 connects the upper tank part 411 and the lower tank part 412. There are provided a plurality of pieces of connecting pipe part 413.

The connecting pipe part 423 of the heat radiation part 420 connects the upper tank part 421 and the lower tank part 422. There are provided a plurality of connecting pipe part 423.

The heat-receiving-part fin part 414 is provided between each piece of connecting pipe part 413. These pieces of heat-receiving-part fin part 414 take heat away from blown air which has become hot, and conduct the received heat to refrigerant COO in the connecting pipe part 423. Refrigerant COO which has received heat causes a phase change into a vapor-phase from a liquid phase, and moves upward in the connecting pipe part 413.

The heat-radiation-part fin part 424 is provided between each piece of connecting pipe part 423 as is the case with the heat-receiving-part fin part 414. The heat-radiation-part fin part 424 radiates heat of refrigerant COO of a vapor-phase which has flowed in from the upper tank part 421. Refrigerant COO from which heat is radiated makes a phase change into a liquid phase from a vapor-phase and descends the connecting pipe part 423 toward the lower tank part 422.

Meanwhile, the heat-receiving-part fin part 414 and the heat-radiation-part fin part 424 include a plurality of fins, and are constituted so that air can pass between a plurality of fins. That is, in the area of the heat-receiving-part fin part 414, air can go through from one main surface of the heat receiving part 410 toward the other main surface. Similarly, in the area of the heat-radiation-part fin part 424, air can go through from one main surface of the heat radiation part 420 toward the other main surface.

The steam pipe 430 connects the upper tank part 411 of the heat receiving part 410 and the upper tank part 421 of the heat radiation part 420. The liquid pipe 440 connects the lower tank part 412 of the heat receiving part 410 and the lower tank part 422 of the heat radiation part 420. In Fig. 6, the steam pipe 430 and the liquid pipe 440 are indicated in a dotted line.

Next, it is as follows about a method to fill refrigerant COO in the aforementioned closed space of the cooling unit 400. First, refrigerant COO is poured in the closed space formed by the inner hollows of the heat receiving part 410 and a heat radiation part 440, the steam pipe 430 and the liquid pipe 440.

Next, air is excluded from the closed space using a vacuum pump (not shown) or the like, and the refrigerant is sealed in this closed space. As a result, the pressure in the space becomes equal to the saturated vapor pressure of the refrigerant, and a boiling point of refrigerant COO that is sealed in the closed space will be near the room temperature. As above, the method to fill refrigerant COO in the above-mentioned closed space of the cooling unit 400 has been described.

Thus, when the cooling unit 400 into which refrigerant COO has been filled is put under an environment of the room temperature, if the heat receiving part 410 receives heat of the electronic substrate 200, refrigerant COO boils at the almost same time with starting of heat reception, and vapor is generated. As a result, the cooling structure including at least the heat receiving part 410, the heat radiation part 420, the steam pipe 430 and the liquid pipe 440 functions as a cooling module, and begins to receive heat from the electronic substrate 200.

That is, the heat receiving part 410 receives heat of the electronic substrate 200 by warm air flowing in from the electronic substrate reception chamber 300a via the warm air exhaust opening 311. When the heat receiving part 410 receives heat of the electronic substrate 200, refrigerant COO boils in the heat receiving part 410 and will be in a vapor-phase state.

Then, refrigerant COO of the vapor-phase state moves upward from the side of the lower tank 412 toward the side of the upper tank 411 through the connecting pipe part 413. During this, the heat-receiving-part fin part 414 receives heat from the electronic substrate 200 included in the warm air.

Next, refrigerant COO of the vapor-phase state in the heat receiving part 410 flows into the heat radiation part 420 through the steam pipe 430. In the heat radiation part 420, by cooling refrigerant COO of the vapor-phase state, heat included in refrigerant COO (heat from the electronic substrate 100) is radiated.

By undergoing condensation and cooling in the heat radiation part 420, refrigerant COO of the vapor-phase state changes a phase into a liquid phase state. At that time, in the heat radiation part 420, refrigerant COO of the liquid phase state moves downward from the upper tank 421 side to the lower tank 422 side. During this, the heat-radiation-part fin part 424 releases heat included in refrigerant COO (heat from the electronic substrate 100) by radiating heat of refrigerant COO which moves downward in the connecting pipe part 423.

Then, refrigerant COO cooled in the heat radiation part 420 becomes in a liquid phase state, pooled in the side of the lower tank 422 of the heat radiation part 420, and refrigerant COO of the liquid phase state flows again into the heat receiving part 410 via the liquid pipe 440.

Thus, refrigerant COO receives heat from warm air passing through the heat receiving part 410 (the warm air is including heat from the electronic substrate 200) by the heat receiving part 410, and circulates through the heat receiving part 410, the steam pipe 430, the heat radiation part 420 and the liquid pipe 440 successively. As a result, heat of the electronic substrate 200 which has been received by the heat receiving part 410 is radiated.

As above, by making refrigerant COO circulate between the heat receiving part 410 and the heat radiation part 420 while changing phases (liquid phase <--> vapor-phase), the cooling unit 400 cools warm air whose heat is received by the heat receiving part 410.

Thus, the structure and operations of the cooling unit 400 have been described.

Next, operations of the electronic substrate housing equipment 100 will be described based on a drawing.

First, when the electronic substrate housing equipment 100 is powered on, the electronic substrate 200 generates heat mainly due to the heater element 220. The heater-element heat receiving part 250 receives generated heat of the heater element 220 and radiates it.

Also, as shown in Fig. 1, by ventilation by the electronic-substrate fan 270, heat of the electronic substrate 200 moves, within the electronic substrate reception chamber 300a, toward the heat receiving part reception chamber 300b taking air in the chassis 300 as a medium (arrow a of Fig. 1). Then, the air (warm air) including heat of the electronic substrate 200 flows into the heat receiving part reception chamber 300b from the electronic substrate reception chamber 300a through the warm air exhaust opening 311 (arrow b of Fig. 1).

Next, in the heat receiving part reception chamber 300b, the heat receiving part 410 of the cooling unit 400 receives heat of the electronic substrate 200 included in the warm air.

Then, the heat radiation part 420 of the cooling unit 400 radiates the heat which has been received by the heat receiving part 410 outside the chassis 300. At that time, because the heat radiation part 420 is provided outside the chassis 300, there is no cases where heat is radiated into the heat receiving part reception chamber 300b and fills it. Therefore, the heat radiation part 420 can radiate heat of the electronic substrate 200 more efficiently.

Here, by making refrigerant COO circulate while changing phases (liquid phase <--> vapor-phase), the cooling unit 400 radiates heat of the electronic substrate 200. More specifically, it is as it has been described using Fig. 5 and Fig. 6 above.

Next, air in the heat receiving part reception chamber 300b flows into the air guiding chamber 300c from the heat receiving part reception chamber 300b through the cold air exhaust opening 312 (arrow c).

At that time, although air flowing into the direction of arrow b through the warm air exhaust opening 311 into the heat receiving part reception chamber 300b includes heat of the electronic substrate 200, heat of this electronic substrate 200 is radiated by the cooling unit 400. For this reason, air (warm air) flowing into the direction of arrow b through the warm air exhaust opening 311 into the heat receiving part reception chamber 300b is cooled by the cooling unit 400.

Accordingly, temperature of air (cold air) flowing into the air guiding chamber 300c through the cold air exhaust opening 312 in the direction of arrow c is lower than the temperature of the air (warm air) passing through the warm air exhaust opening 311 in the direction of arrow b.

Thus, by forming the warm air exhaust opening 311 and the cold air supply opening 312 into the intake/exhaust air division plate 310 separately, it is possible to prevent warm air which flows into the heat receiving part reception chamber 300b from the electronic substrate reception chamber 300a and cold air which flows into the air guiding chamber 300c from the heat receiving part reception chamber 300b mixing with each other.

Next, by the electronic-substrate fan 270, the air that has flowed into the air guiding chamber 300c from the heat receiving part reception chamber 300b moves, within the air guiding chamber 300c, toward the direction of arrow d and flows into the electronic substrate reception chamber 300a again through the communication part 321.

In this way, by the electronic-substrate fan 270, air including heat from the electronic substrate 200 circulates through the electronic substrate reception chamber 300a, the heat receiving part reception chamber 300b and the air guiding chamber 300c successively in the chassis 300. That is, air including heat from this electronic substrate 200 passes through the electronic substrate reception chamber 300a, the heat receiving part reception chamber 300b and the air guiding chamber 300c, and flows into the electronic substrate reception chamber 300a again.

Then, heat from the electronic substrate 200 that is included in air circulating in the chassis 300 is received by the heat receiving part 410 provided in the heat receiving part reception chamber 300b in particular, and radiated by the heat radiation part 420 provided outside the chassis 300. As a result, heat from the electronic substrate 200 can be exhausted outside the airtight chassis 300. Accordingly, efficient cooling of the electronic substrate housing equipment 100 is possible.

Above, operations of the electronic substrate housing equipment 100 have been described.

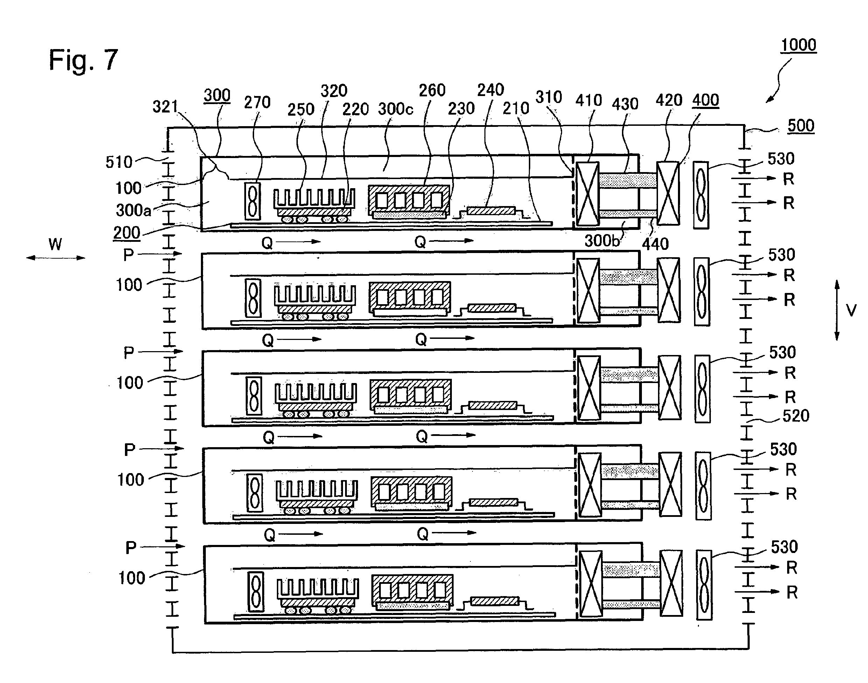

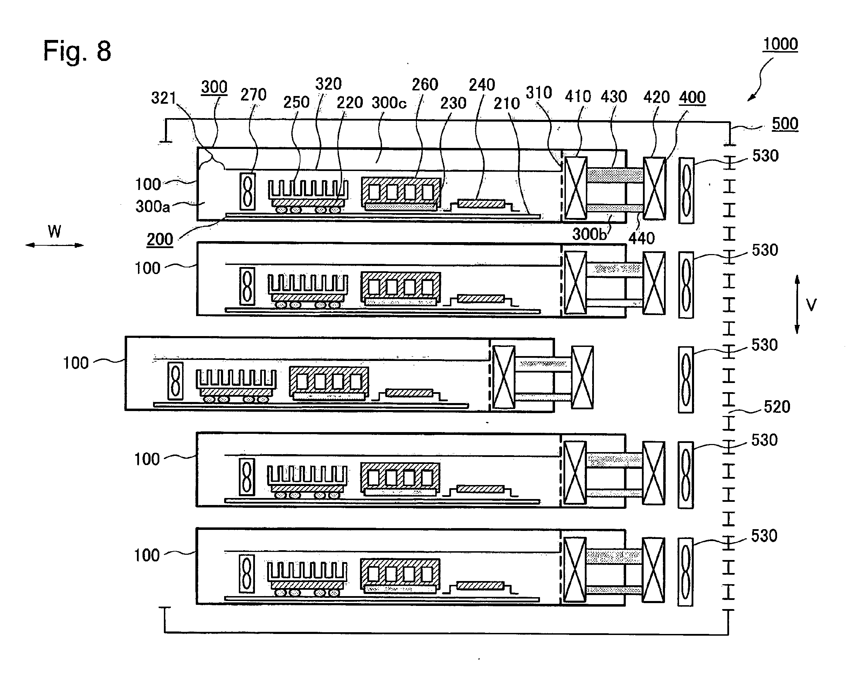

Next, a configuration of the electronic apparatus 1000 will be described based on a drawing. Fig. 7 and Fig. 8 are side perspective views showing a structure of the electronic apparatus 1000 in the first exemplary embodiment of the present invention seen in a penetrated manner from a side. Fig. 7 indicates a state that pieces of electronic substrate housing equipment 100 are housed. Fig. 8 indicates a state that the electronic substrate housing equipment 100 is attached and detached.

Meanwhile, as described in detail in the later explanation, in Fig. 7, a plurality of pieces of air intake vent 510 are being shown in the front face of a rack 500. In contrast, in Fig. 8, a state that the front face of the rack 500 including a plurality of pieces of air intake vent 510 is being removed is indicated. Thus, the front face including a plurality of pieces of air intake vent 510 can be removed from the rack 500 when the electronic substrate housing equipment 100 is attached and detached.

As shown in Fig. 7 and Fig. 8, the electronic apparatus 1000 is constituted including pieces of electronic substrate housing equipment 100 and the rack 500.

The rack 500 can house the electronic substrate housing equipment 100. For example, there are provided projections (not shown) in the outside of each of two side faces (the front side and the rear side of the sheets of Fig. 7 and Fig. 8) of the electronic substrate housing equipment 100. Also, rails (not shown) corresponding to the projections of the electronic substrate housing equipment 100 are provided inside the two side faces (the front side and the rear side of the sheets of Fig. 7 and Fig. 8) of the rack 500.

The projections of the electronic substrate housing equipment 100 and the rails of the rack 500 are provided such that they extend in an approximately perpendicular direction against the vertical direction V together. Accordingly, the electronic substrate housing equipment 100 is installed along an approximately perpendicular direction against the vertical direction V so that it can be inserted to and removed from the rack 500.

In Fig. 7 and Fig. 8, there is shown insert/remove direction W of the electronic substrate housing equipment 100. That is, as shown in Fig. 8, by inserting the electronic substrate housing equipment 100 into the rack 500 along an approximately perpendicular direction against the vertical direction V, the electronic substrate housing equipment 100 can be installed in the rack 500.

Conversely, by pulling out the electronic substrate housing equipment 100 from the rack 500 along an approximately perpendicular direction against the vertical direction V, the electronic substrate housing equipment 100 can be removed from the rack 500.

The configuration of the electronic substrate housing equipment 100 has been already described in detail using Figs. 1-6. Here, a configuration of the rack 500 will be described based on a drawing.

As shown in Fig. 7, the rack 500 has a plurality of pieces of air intake vent 510, a plurality of pieces of exhaust vent 520 and a rack fan part 530.

In order to take air outside the rack 500 into the rack 500, the air intake vent 510 is being provided in the front side of the rack 500 (the left side of the sheet of Fig. 7).

In order to discharge air in the rack 500 outside the rack 500, the exhaust vent 520 is provided in the rear side of the rack 500 (the right side of the sheet of Fig. 7).

The rack fan part 530 is provided in the rear side of the rack 500 (the right side of the sheet of Fig. 7). The rack fan part 530 is making air flowing in from the air intake vent 510 flow out to the exhaust vent 520 compulsorily. As shown in Fig. 7 and Fig. 8, each of the plurality of pieces of rack fan part 530 is arranged in the rack 100 so that it may correspond to each piece of electronic substrate housing equipment 100.

Next, operations of the electronic apparatus 1000 in the first exemplary embodiment of the present invention will be described based on a drawing. Meanwhile, description of the operations of the electronic substrate housing equipment 100 has been already made in detail. Accordingly, in the following description, description of operations of the electronic substrate housing equipment 100 housed in the electronic apparatus 1000 will be simplified.

As shown in Fig. 7, in the rack 500, when the rack fan part 530 is operated, air outside the rack 500 is drawn in from the air intake vent 510 (arrow P), first.

Next, air drawn in from the air intake vent 510 moves toward the rear side of the rack 500 passing through between each electronic substrate housing equipment 100 (arrow Q). Then, the air having passed through between pieces of electronic substrate housing equipment 100 is emitted from the exhaust vent 520 to outside the rack 500 (arrow R).

At that time, in the rear side of the rack 500 (the right side of the sheet of Fig. 7), the cooling unit 400 is radiating heat of the electronic substrate 200 placed in the chassis 300. That is, the heat receiving part 410 of the cooling unit 400 is receiving, within the chassis 300, heat of the electronic substrate 200, and the heat radiation part 420 of the cooling unit 400 is radiating the heat received by the heat receiving part 410 to outside the chassis 300.

Accordingly, heat of the electronic substrate 200 that is radiated from the heat radiation part 420 to outside the chassis 300 flows out to outside the rack 500 via the exhaust vent 520 taking air flowing in from the air intake vent 510 by ventilation of the rack fan part 530 as a medium.

As mentioned above, the electronic substrate housing equipment 100 in the first exemplary embodiment of the present invention has the electronic substrate 200, the chassis 300 and the cooling unit 400. The electronic substrate 200 mounts the heater element 220. The chassis 300 houses the electronic substrate 200 in a manner making it airtight. The cooling unit 400 cools the electronic substrate 200. Also, the cooling unit 400 includes the heat receiving part 410 and the heat radiation part 420. The heat receiving part 410 receives heat from the electronic substrate 200. The heat radiation part 420 is in connection with the heat receiving part 410, and radiates heat from the electronic substrate 200 received by the heat receiving part 410.

The heat receiving part 410 is provided in the chassis 300 in a manner being airtight, and the heat radiation part 420 is provided outside the chassis 300.

Thus, the heat receiving part 410 receives, within the airtight chassis 300, heat from the electronic substrate 200. And the heat radiation part 420 radiates heat from the electronic substrate 200 which has been received by the heat receiving part 410. At that time, because the heat radiation part 420 is being installed outside the chassis 300, it is possible to radiate heat of the electronic substrate 200 outside the chassis 300.

Accordingly, in the electronic substrate housing equipment 100, it is possible to radiate heat from the electronic substrate 200 that is sealed up in the chassis 300 to outside the chassis 300. As a result, heat of the electronic substrate 200 can be radiated efficiently in the electronic substrate housing equipment 100 because, in spite of the state that the electronic substrate 200 is sealed up in the chassis 300 being still kept, there are no cases that exhaust heat from the electronic substrate 200 is filled in the chassis 300.

Furthermore, because the electronic substrate 200 is housed in the chassis 300 in an airtight manner, intrusion of trash and dust into the chassis 300 from outside the chassis 300 can be prevented even when electronic substrate housing equipment is replaced at the time of maintenance operations and at the time of replacement work.

Thus, according to the electronic substrate housing equipment 100 in the first exemplary embodiment of the present invention, efficient cooling is possible, and moreover, maintenance replacement work can be performed for each piece of electronic substrate housing equipment 100 individually.

In addition, in the technology described in patent document 1, a power supply is necessary in order to make a vapor heat exchanger operate. Further, in order to make it possible to cool the maximum number of electronic modules which can be stacked in the inner space within a network cabinet, required electric power is being set.

For this reason, there is a problem that, even in a case where a small number of electronic modules are mounted into the inner space, electric power required for cooling the maximum number of electronic modules is spent always by the operation of a vapor heat exchanger, and thus a wasteful electric power is consumed.

In contrast, in the electronic substrate housing equipment 100 in the first exemplary embodiment of the present invention, the cooling unit 400 is provided for each piece of the electronic substrate housing equipment 100 separately. For this reason, a wasteful electric power such as spending a required electric power for cooling the maximum number of pieces of electronic substrate housing equipment which can be mounted is not consumed unlike the technology described in patent document 1.

Also, in the electronic substrate housing equipment 100 in the first exemplary embodiment of the present invention, the chassis 300 includes the electronic substrate reception chamber 300a, the heat receiving part reception chamber 300b, the air guiding chamber 300c, the division plate 310, the partition plate 320 and the first to third openings (the warm air exhaust opening 311, the cold air supply opening 312 and the communication hole 321). The electronic substrate reception chamber 300a houses the electronic substrate 200. The heat receiving part reception chamber 300b houses the heat receiving part 410. The air guiding chamber 300c composes a flow path of air between the heat receiving part reception chamber 300b and the electronic substrate reception chamber 300a.

The intake/exhaust air division plate 310 is provided between the heat receiving part reception chamber 300b and each of the electronic substrate reception chamber 300a and the air guiding chamber 300c. The partition plate 320 is provided between the air guiding chamber 300c and the electronic substrate reception chamber 300a. The first opening (the warm air exhaust opening 311) is formed into the intake/exhaust air division plate 310, and it links between the electronic substrate reception chamber 300a and the heat receiving part reception chamber 300b. The second opening (the cold air supply opening 312) is formed into the intake/exhaust air division plate 310, and it links between the heat receiving part reception chamber 300b and the air guiding chamber 300c. The third opening (the communication part 321) is formed into the partition plate 320, and links the air guiding chamber 300c and the electronic substrate reception chamber 300a. And, by using the electronic-substrate fan 270 for example, a flow path of air which circulates through between the electronic substrate reception chamber 300a, the heat receiving part reception chamber 300b and the air guiding chamber 300c is constituted through the first opening (the warm air exhaust opening 311), the second opening (the cold air supply opening 312) and the third opening (the communication hole 321).

Thus, in the electronic substrate housing equipment 100, the chassis 300 is being divided into three rooms of the electronic substrate reception chamber 300a, the heat receiving part reception chamber 300b and the air guiding chamber 300c using the intake/exhaust air division plate 310 and the partition plate 320. Also, the first opening (the warm air exhaust opening 311) and the second opening (the cold air supply opening 312) are formed into the intake/exhaust air division plate 310, and the third opening (the communication part 321) is formed into the partition plate 320.

As a result, air in the chassis 300 is made to circulate through between the electronic substrate reception chamber 300a, the heat receiving part reception chamber 300b and the air guiding chamber 300c. By arranging the heat receiving part 410 that is being provided in the heat receiving part reception chamber 300b in the circulation way of air in the chassis 300, the heat receiving part 410 can receive heat from the electronic substrate 200 that is included in the circulating air efficiently.

In particular, the warm air exhaust opening 311 and the cold air supply opening 312 are divided separately, and are formed into the intake/exhaust air division plate 310. As a result, it is possible to prevent warm air which flows into the heat receiving part reception chamber 300b from the electronic substrate reception chamber 300a and cold air which flows into the air guiding chamber 300c from the heat receiving part reception chamber 300b mixing with each other.

In the electronic substrate housing equipment 100 in the exemplary embodiment of the present invention, the heat receiving part 410 is provided such that it faces the first opening (the warm air exhaust opening 311). As a result, the heat receiving part 410 can receive heat from the electronic substrate 200 that flows in from the warm air exhaust opening 311 efficiently.

In the electronic substrate housing equipment 100 in the first exemplary embodiment of the present invention, it has the electronic-substrate fan 270 provided in the electronic substrate reception chamber. This electronic-substrate fan 270 is provided such that the heater element 220 is arranged between the electronic-substrate fan 270 and the first opening (the warm air exhaust opening 311).

The electronic-substrate fan 270 promotes that air in the chassis 300 circulates between the electronic substrate reception chamber 300a, the heat receiving part reception chamber 300b and the air guiding chamber 300c. As a result, generated heat of the heater element 220 can be cooled directly by blown air by the electronic-substrate fan 270.

In addition, blown air by the electronic-substrate fan 270 becomes warm air by including heat of the electronic substrate 200 that includes heat of the heater element 220 mainly, and flows into the heat receiving part reception chamber 300b through the warm air exhaust opening 311. For this reason, the heat receiving part 410 can receive heat from the electronic substrate 200 that flows in from the warm air exhaust opening 311 efficiently.

In the electronic substrate housing equipment 100 in the first exemplary embodiment of the present invention, the cooling unit 400 has refrigerant COO which circulates through between the heat receiving part 410 and the heat radiation part 420 in its interior.

Also, the heat receiving part 410 receives heat from the electronic substrate 100, and transfers the received heat to refrigerant COO. The heat radiation part 420 makes refrigerant COO flowing in from the heat receiving part 410 condensed.

Thus, by using refrigerant COO, heat of the electronic substrate 100 can be transferred from the heat receiving part 410 to the heat radiation part 420 efficiently.

Meanwhile, in the electronic substrate housing equipment 100 in the first exemplary embodiment of the present invention, the intake/exhaust air division plate 310 can be divided into two pieces. That is, the intake/exhaust air division plate 310 can be divided into a first intake/exhaust air division plate (not shown) and a second intake/exhaust air division plate (not shown), for example.

At that time, the first intake/exhaust air division plate is provided between the electronic substrate reception chamber 300a and the heat receiving part reception chamber 300b. The second intake/exhaust air division plate is provided between the heat receiving part reception chamber 300b and the air guiding chamber 300c.

Also, the first opening (the warm air exhaust opening 311) is formed into the first intake/exhaust air division plate. The second opening (the cold air supply opening 312) is formed into the second intake/exhaust air division plate. Thus, even if the intake/exhaust air division plate 310 is divided into two pieces, it has the same effect as the effect mentioned above.

### <Second exemplary embodiment>

A configuration of electronic substrate housing equipment 100A in the second exemplary embodiment of the present invention will be described based on a drawing.

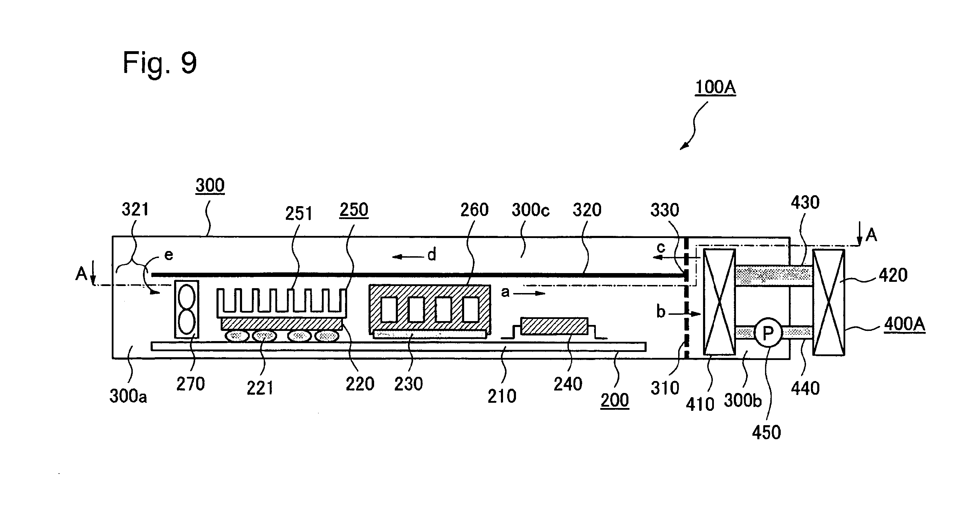

Fig. 9 is a sectional view showing a structure of the electronic substrate housing equipment 100A seen through from a side. The electronic substrate housing equipment 100A can be installed in the rack 500 shown in Fig. 7 and Fig. 8. That is, the electronic apparatus 1000 is formed by installing the electronic substrate housing equipment 100A instead of the electronic substrate housing equipment 100 shown in Fig. 7 and Fig. 8.

Meanwhile, in Fig. 9, a symbol equal to a symbol shown in Figs. 1-8 is attached to a component equal to each component shown in Figs. 1-8.

As shown in Fig. 9, the electronic substrate housing equipment 100A is constituted including the electronic substrate 200, the chassis 300 and a cooling unit 400A.

Here, Fig. 1 and Fig. 9 are compared. The structures of the electronic substrate 200 and the chassis 300 are identical, respectively, in Fig. 1 and Fig. 9. In contrast, the cooling unit 400A of Fig. 9 is different from the cooling unit 400 of Fig. 1 in a point that it includes a pump part 450.

That is, the cooling unit 400A is constituted including the heat receiving part 410, the heat radiation part 420, the steam pipe 430, the liquid pipe 440 and the pump part 450. The pump part 450 is provided in the liquid pipe 440.

The pump part 450 makes circulation of refrigerant COO between the heat receiving part 410 and the heat radiation part 420 be promoted. As a result, refrigerant COO can be made to circulate through between the heat receiving part 410 and the heat radiation part 420 more efficiently while changing phases (liquid phase <--> vapor-phase). As a result, according to the electronic substrate housing equipment 100A, heat of the electronic substrate 200 which is received by the heat receiving part 410 can be radiated more efficiently.

### <Third exemplary embodiment>

A configuration of electronic substrate housing equipment 100B in the third exemplary embodiment of the present invention will be described based on a drawing.

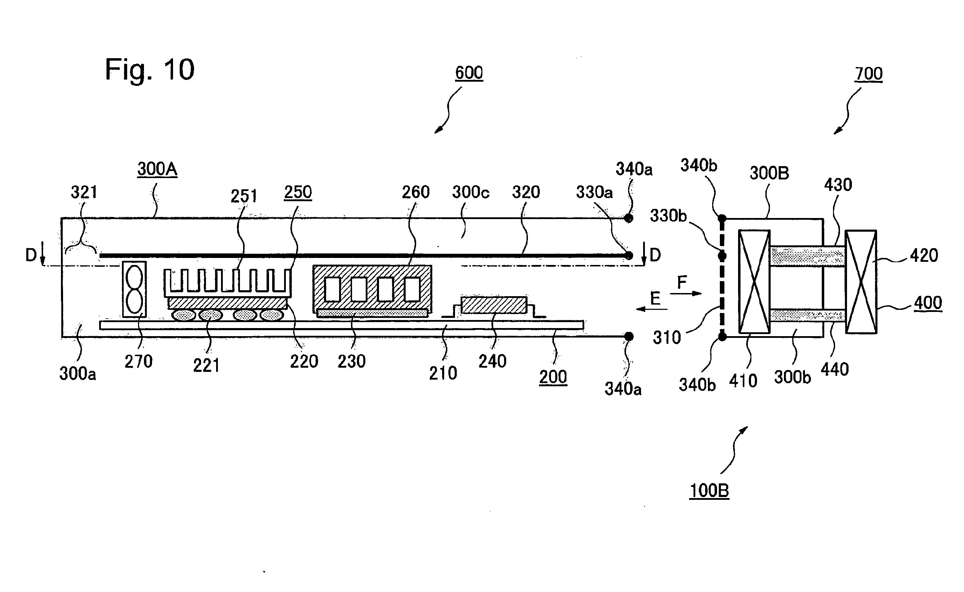

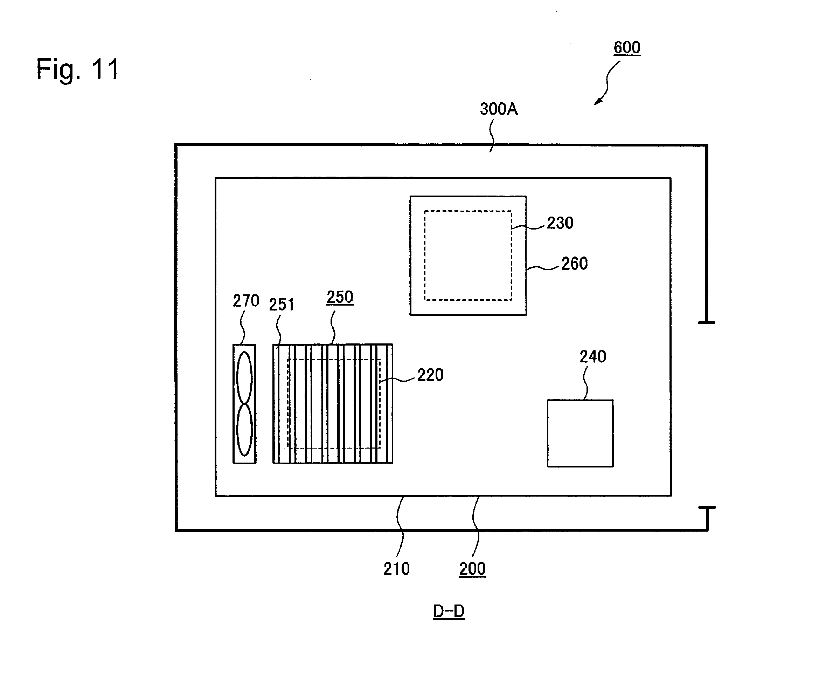

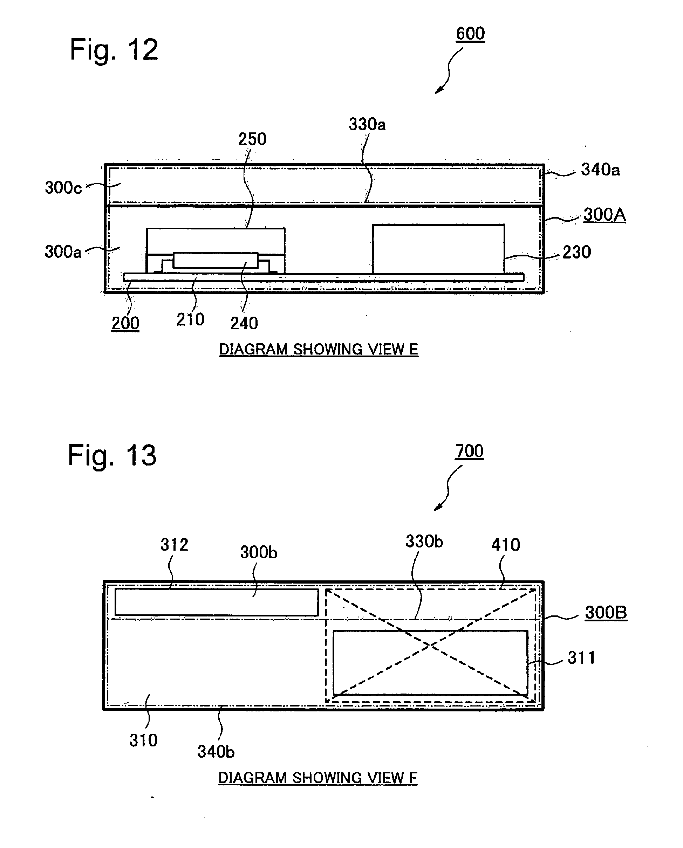

Fig. 10 is a side face perspective view showing a structure of the electronic substrate housing equipment 100B in the third exemplary embodiment of the present invention seen through from a side. Fig. 11 is a surface perspective view seen from cutting plane D-D of Fig. 10. Fig. 12 is a diagram showing view E of Fig. 10. Fig. 13 is a diagram showing view F of Fig. 10.

Meanwhile, in Figs. 10-12, a symbol equal to a symbol shown in Figs. 1-9 is attached to a component equal to each component shown in Figs. 1-9.

As shown in Fig. 10, the electronic substrate housing equipment 100B is constituted including first electronic equipment 600 and second electronic equipment 700.

Here Fig. 1 and Fig. 10 are compared. In Fig. 1, the electronic substrate housing equipment 100 is of one piece. In contrast, in Fig. 10, the electronic substrate housing equipment 100B is constituted being separated in two pieces of the first electronic equipment 600 and the second electronic equipment 700.

Meanwhile, the first electronic equipment 600 and the second electronic equipment 700 are connected by joints 330a, 330b, 340a and 340b. The resulting object made by connecting the first electronic equipment 600 and the second electronic equipment 700 by the joints 330a, 330b, 340a and 340b has the same basic structure as the electronic substrate housing equipment 100 shown in Fig. 1.

As shown in Figs. 10-12, the first electronic equipment 600 is constituted including a first chassis 300A and the electronic substrate 200. Meanwhile, the first chassis 300A has the same basic structure as the chassis 300 indicated in the first exemplary embodiment by being connected with the second chassis 300B that will be described later.

As shown in Figs. 10-12, the first chassis 300A has the electronic substrate reception chamber 300a and the air guiding chamber 300c. The electronic substrate 200 is housed in the electronic substrate reception chamber 300a. The partition plate 320 is being provided between the electronic substrate reception chamber 300a and the air guiding chamber 300c like the first exemplary embodiment. The communication hole 321 is formed into the partition plate 320.

As shown in Figs. 10-12, the joint 330a and the joint 340a are provided in ends of the first chassis 300A. In Fig. 12, the joint 330a is indicated by a dot-dash line and the joint 340a by a two dotted line. Meanwhile, for convenience, although the two dotted line is indicated being shifted from the visible outline of the chassis 300A in each of the figures, the joint 340a is provided along the outline of the chassis 300A in a quadrangle shape in reality.

Similarly, although the dot-dash line is indicated being shifted from the partition plate 320 in each of the figures, the joint 330a is formed along the partition plate 320 in a straight line actually. The joint 330a is connected with the joint 330b provided in the second chassis 300B mentioned later.

The joint 340a is connected with the joint 340b provided in the second chassis 300B mentioned later.

Meanwhile, the joint 330a is provided in an end face of the partition plate 320. The joint 340a is provided in an end face that faces the second electronic equipment 700 in Fig. 10 among faces of the first chassis 300A. There is used a cushion of viscoelasticity, for example, for the connection of the joint 330a and the joint 330b and the connection of the joint 340a and the joint 340b. This cushion is provided along the joint 330a and the joint 330b, for example.

As shown in Fig. 10 and Fig. 13, the second chassis 300B has the heat receiving part reception chamber 300b. The heat receiving part 410 is housed in the heat receiving part reception chamber 300b. As shown in Fig. 10, the intake/exhaust air division plate 310 is provided in an end of the second chassis 200B. Also, as shown in Fig. 13, the warm air exhaust opening 311 and the cold air supply opening 312 are formed in the intake/exhaust air division plate 310.

Further, as shown in Fig. 10 and Fig. 13, the joint 330b and the joint 340b are provided in the intake/exhaust air division plate 310. These joint 330b and joint 340b are provided linearly corresponding to the joint 330a and the joint 340a.

The configurations of these joint 330b and joint 340b will be described more specifically. As mentioned above, the joint 330a is an end face of the partition plate 320. The joint 340a is an end face of the chassis 300A. Accordingly, the joint 330b and the joint 340b are formed with a width corresponding to plate thicknesses of the partition plate 320 and the first chassis 300A in a line shape.

In Fig. 13, the joint 330b is indicated by a dot-dash line and the joint 340b by a two dotted line. Meanwhile, although the two dotted line is indicated being shifted from the visible outline of the chassis 300B in each of the figures for convenience, the joint 340b is being provided along the outline of the chassis 300A in a quadrangle shape actually.

The joint 330b is provided between the warm air exhaust opening 311 and the cold air supply opening 312 in a straight line shape. The joint 330b is connected with the joint 330a provided in the first chassis 300A. The joint 340b is connected with the joint 340a provided in the first chassis 300A mentioned later.

As mentioned above, there is used a cushion of viscoelasticity, for example, for the connection of the joint 330a and the joint 330b and the connection of the joint 340a and the joint 340b. This cushion is provided along the joint 330a and the joint 330b, for example.

As above, the configuration of the electronic substrate housing equipment 100B has been described. Meanwhile, because the operations of the electronic substrate housing equipment 100B is similar to the electronic substrate housing equipment 100 in the first exemplary embodiment, detailed description will be omitted.

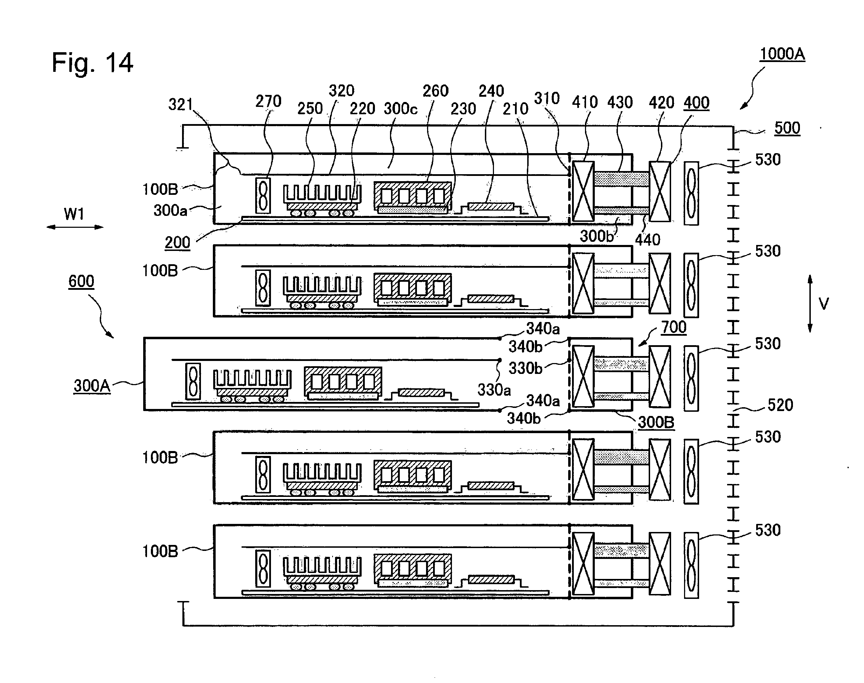

Next, a configuration of electronic apparatus 1000A in the third exemplary embodiment of the present invention will be described based on a drawing. Fig. 14 is a side face perspective view showing a structure of the electronic apparatus 1000A in the third exemplary embodiment of the present invention seen through from a side. Fig. 14 indicates a state that the first electronic equipment 600 of the electronic substrate housing equipment 100B is attached and detached.

Meanwhile, in Fig. 14, a symbol equal to a symbol shown in Figs. 1-13 is attached to a component equal to each component shown in Figs. 1-13.

As shown in Fig. 14, the electronic apparatus 1000A is constituted including the electronic substrate housing equipment 100B and the rack 500. As mentioned above, the electronic substrate housing equipment 100B can be separated into the first electronic equipment 600 and second electronic equipment 700.

The rack 500 is identical with the one shown in Fig. 7. Accordingly, although not shown in Fig. 14, the inlet 510 is provided in the front face of the rack 500 as shown in Fig. 7, and this front face can be removed.

Here, Fig. 8 and Fig. 14 are compared. In Fig. 8, the whole of the electronic substrate housing equipment 100 is constituted in a removable manner relative to the rack 500. In contrast, in Fig. 14, the second electronic equipment 700 of the electronic substrate housing equipment 100B is being installed in the rack 500 in advance. And, only the first electronic equipment 600 of the electronic substrate housing equipment 100B is constituted in a removable manner relative to the rack 500.

Projections (not shown) are provided in two outside side faces of the first electronic equipment 600 (the front side and the rear side of the sheet of Fig. 14) as is the case with the electronic substrate housing equipment 100 in the first exemplary embodiment. Also, there are provided rails (not shown) corresponding to the projections of the first electronic equipment 600 inside two side faces of the rack 500 (the front side and the rear side of Fig. 14).

The projections of the first electronic equipment 600 and the rails of the rack 500 are provided such that they extend in an approximately perpendicular direction against the vertical direction V together. Accordingly, the first electronic equipment 600 is installed along an approximately perpendicular direction against the vertical direction V so that it can be inserted to and removed from the rack 500. In Fig. 14, there is shown insert/remove direction W1 of the first electronic equipment 600.

That is, as shown in Fig. 14, by inserting the first electronic equipment 600 into the rack 500 along an approximately perpendicular direction against the vertical direction V, the joints 330a and 340a of the first electronic equipment 600 are connected with the joints 330a and 340b of the second electronic equipment.

There is used a cushion of viscoelasticity, for example, for the connection of the joint 330a and the joint 330b and the connection of the joint 340a and the joint 340b. This cushion is provided along the joint 330a and the joint 330b, for example.

Meanwhile, after the joints 340a and 340b have been connected with the joints 330a and 340a each other, the first electronic equipment 600 is held to the rack 500 by screwing or the like. As a result, the connection states between the joints 330a and 340a and the joints 340a and the 340b are maintained.

In this way, the first electronic equipment 600 is installed into the rack 500. As a result, the first electronic equipment 600 and the second electronic equipment 700 are connected by the joints, 330a, 330b, 340a and 340b, and the electronic substrate housing equipment 100B will be completed in the rack 500.

Conversely, by pulling out the first electronic equipment 600 from the rack 500 along an approximately perpendicular direction against the vertical direction V, the joints 330a and 340a of the first electronic equipment 600 and the joints 340a and 340b of the second electronic equipment 700 are freed from the connection state.

When a cushion of viscoelasticity, for example, is used for the connection of the joint 330a and the joint 330b and the connection of the joint 340a and the joint 340b, by taking out the first electronic equipment 600 from the rack 500, such connection state is freed. As a result, the first electronic equipment 600 is removed from the rack 500.

Above, the configuration of the electronic apparatus 1000A has been described based on a drawing. Operations of the electronic apparatus 1000A are similar to those of the electronic apparatus 1000 in the first exemplary embodiment. Accordingly, here, description of the operations of the electronic apparatus 1000A will be omitted.

As above the electronic substrate housing equipment 100B in the third exemplary embodiment of the present invention is constituted including the first electronic equipment 600, the second electronic equipment 700 and the joints 330a, 330b, 340a and 340b. The first electronic equipment 600 is constituted including the first chassis 300A and the electronic substrate 200. The first chassis 300A is constituted including the electronic substrate reception chamber 300a and the air guiding chamber 300c. The second electronic equipment 700 is constituted including the second chassis 300B and the cooling unit 400. The second chassis 300B has the heat receiving part reception chamber 300b. The heat receiving part 410 of the cooling unit 400 is provided in the heat receiving part reception chamber 300b. The electronic substrate housing equipment 100B has the joints 330a, 330b, 340a and 340b that connect the first electronic equipment 600 and the second electronic equipment 700.

Thus, the electronic substrate housing equipment 100B can be composed so that it may be separated into the first electronic equipment 600 and the second electronic equipment 700, and they may be connected by the joints 330a, 330b, 340a and 340b. For example, by installing the second electronic equipment 700 in the rack in advance, even at the time of maintenance replacement of the electronic device accommodation equipment 100B, only the first electronic equipment 600 in the electronic substrate housing equipment 100B has to be installed or removed, and thus maintenance replacement work becomes easy.

### <Fourth exemplary embodiment>

A configuration of electronic substrate housing equipment 100C and electronic apparatus 1000B in the fourth exemplary embodiment of the present invention will be described based on a drawing.

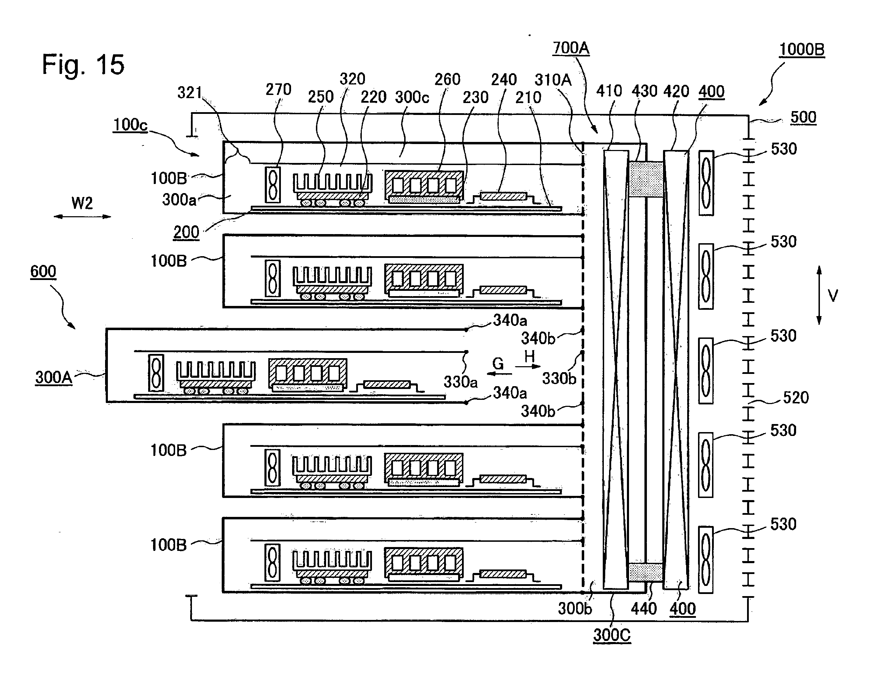

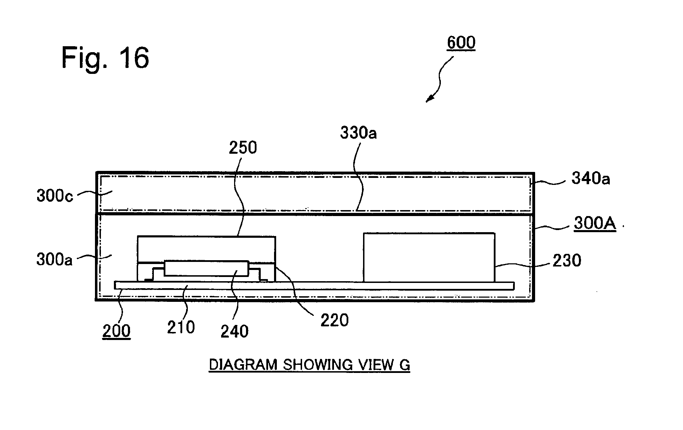

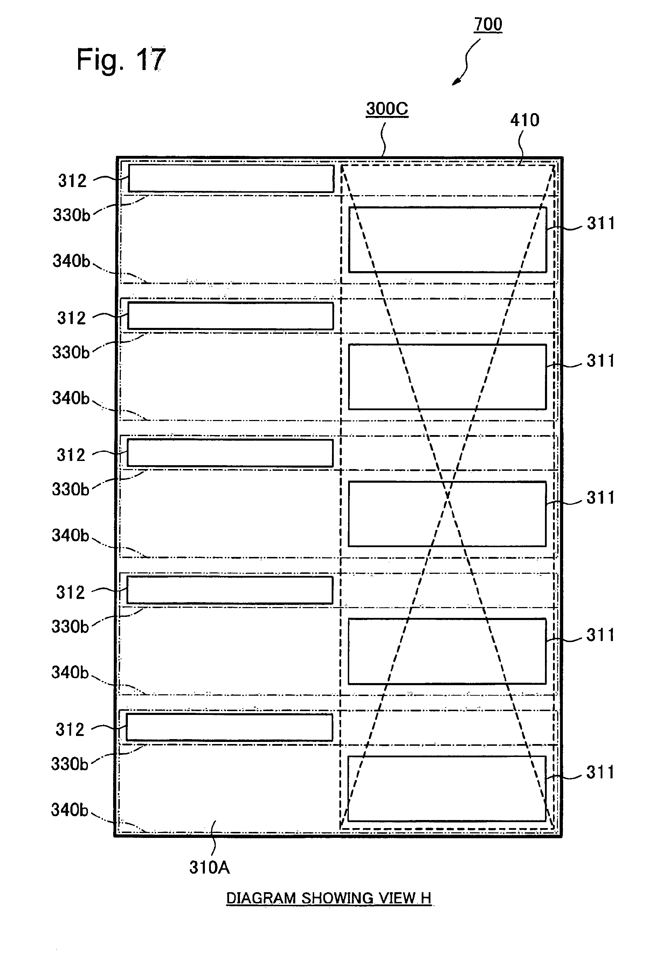

Fig. 15 is a side face perspective view showing a structure of the electronic apparatus 1000B in the fourth exemplary embodiment of the present invention seen through from a side. Fig. 16 is a diagram showing view G of Fig. 15. This Fig. 16 is identical with Fig. 12. Fig. 17 is a diagram showing view H of Fig. 15.

Meanwhile, in Figs. 15-17, a symbol equal to a symbol shown in Figs. 1-14 is attached to a component equal to each component shown in Figs. 1-14.

As shown in Fig. 15, the electronic apparatus 1000B is constituted including the electronic substrate housing equipment 100C and the rack 500. The electronic substrate housing equipment 100C is constituted including a plurality of pieces of first electronic equipment 600 and second electronic equipment 700A.

In Fig. 15, the second electronic equipment 700A of the electronic substrate housing equipment 100C is installed in the rack 500 in advance. Only the first electronic equipment 600 of the electronic substrate housing equipment 100C is constituted so that it can be inserted to and removed from the rack 500.

As is the case with the description in the third exemplary embodiment, projections (not shown) are provided in outside two side faces of the first electronic equipment 600 (the front side and the rear side of the sheet of Fig. 15). Also, rails (not shown) corresponding to the projections of the first electronic equipment 600 are provided inside two side faces of the rack 500 (the front side and the rear side of the sheet of Fig. 15).

The projections of the first electronic equipment 600 and the rails of the rack 500 are provided such that they extend in an approximately perpendicular direction against the vertical direction V together. Accordingly, the first electronic equipment 600 is installed along an approximately perpendicular direction to the vertical direction V so that it can be inserted to and removed from the rack 500. There is shown insert/remove direction W2 of the first electronic equipment 600 in Fig. 15.

That is, as shown in Fig. 15, by inserting the first electronic equipment 600 into the rack 500 along an approximately perpendicular direction to the vertical direction V, the joints 330a and 340a of the first electronic equipment 600 are connected with the joints 340a and 340b of the second electronic equipment 700A.

There is used a cushion of viscoelasticity, for example, for the connection of the joint 330a and the joint 330b and the connection of the joint 340a and the joint 340b. Meanwhile, after the joint 340a and 340b have been connected with the joint 330a and 340a each other, the first electronic equipment 600 is held in the rack 500 by screwing or the like. As a result, the connection state between the joints 330a and 340a and the joints 340a and 340b are maintained.

As a result, the first electronic equipment 600 is installed in the rack 500. As a result, the first electronic equipment 600 and the second electronic equipment 700A are connected by the joints 330a, 330b, 340a and 340b, and the electronic substrate housing equipment 100B is completed in the rack 500.

Conversely, by pulling out the first electronic equipment 600 from the rack 500 along an approximately perpendicular direction against the vertical direction V, the joints 330a and 340a of the first electronic equipment 600 and the joints 340a and 340b of the second electronic equipment 700A are freed from the connection state.

When a cushion of viscoelasticity, for example, is used for the connection of the joint 330a and the joint 330b and the connection of the joint 340a and the joint 340b, by taking out the first electronic equipment 600 from the rack 500, the connection state is freed. As a result, the first electronic equipment 600 can be removed from the rack 500.

Here, Fig. 14 and Fig. 15 are compared. In Fig. 14, the electronic substrate housing equipment 100B includes one piece of first electronic equipment 600 and one piece of second electronic equipment 700. In contrast, the electronic substrate housing equipment 100C by this exemplary embodiment shown in Fig. 15 includes a plurality of pieces of first electronic equipment 600 and one piece of second electronic equipment 700A. That is, the second electronic equipment 700A is constituted so that a plurality of pieces of first electronic equipment 600 may be installed.

Because the configuration of the first electronic equipment 600 has been already described in detail in the third exemplary embodiment, detailed description will be omitted.

As shown in Fig. 15 and Fig. 17, the second electronic equipment 700A is constituted so that a plurality of pieces of first electronic equipment 600 can be installed. The second electronic equipment 700A is constituted including a second chassis 300C and the cooling unit 400. The second chassis 300C has the heat receiving part reception chamber 300b. The heat receiving part 410 of the cooling unit 400 is housed in the heat receiving part reception chamber 300b.

As shown in Fig. 15, an intake/exhaust air division plate 310A is provided in an end of the second chassis 300C. A plurality of pieces of warm air exhaust opening 311 and cold air supply opening 312 are formed into the intake/exhaust air division plate 310A.

As shown in Fig. 15 and Fig. 17, the joint 330b and the joint 340b are provided in the intake/exhaust air division plate 310. These joints 330b and 340b are provided in positions corresponding to the joints 330a and 340b of the first electronic equipment 600.

In Fig. 17, the joint 330b is indicated by a dot-dash line and the joint 340b by a two dotted line. The joint 330b is provided in a straight line manner between the warm air exhaust opening 311 and the cold air supply opening 312. The joint 340b is provided in a quadrangle shape such that the warm air exhaust opening 311 and the cold air supply opening 312 are enclosed.

As is the case with the structure described in the third exemplary embodiment, these joint 330b and joint 340b are formed having a width corresponding to the plate thicknesses of the partition plate 320 and the first chassis 300A in a line shape.

The joint 330b is connected with the joint 330a provided in the first chassis 300A. The joint 340b is connected with the joint 340a provided in the first chassis 300A mentioned later.

There is used a cushion of viscoelasticity, for example, for the connection of the joint 330a and the joint 330b and the connection of the joint 340a and the joint 340b. Meanwhile, after the joints 340a and 340b have been connected with the joints 330a and 340a each other, the first electronic equipment 600 is held to the rack 500 by screwing or the like. As a result, the connection state between the joints 330a and 340a and the joints 340a and 340b are maintained.

Above, the configuration of the electronic substrate housing equipment 100C and the electronic apparatus 1000B have been described. Meanwhile, because operations of the electronic substrate housing equipment 100C and the electronic apparatus 1000B are similar to those of the electronic substrate housing equipment 100 and the electronic apparatus 1000 in the first exemplary embodiment, detailed description will be omitted.

As above, in the electronic substrate housing equipment 100C in the fourth exemplary embodiment of the present invention, the second electronic equipment 700A is constituted so that a plurality of first electronic equipment 600 are connected to it. As a result, it is not necessary to provide a plurality of pieces of second electronic equipment 700 correspond to each of a plurality of pieces of first electronic equipment 600, unlike the electronic apparatus 1000A described in the third exemplary embodiment. For this reason, the structure of the electronic apparatus 1000B can be made easy.

### <Fifth exemplary embodiment>

A configuration of electronic substrate housing equipment 100D in the fifth exemplary embodiment of the present invention will be described based on a drawing.

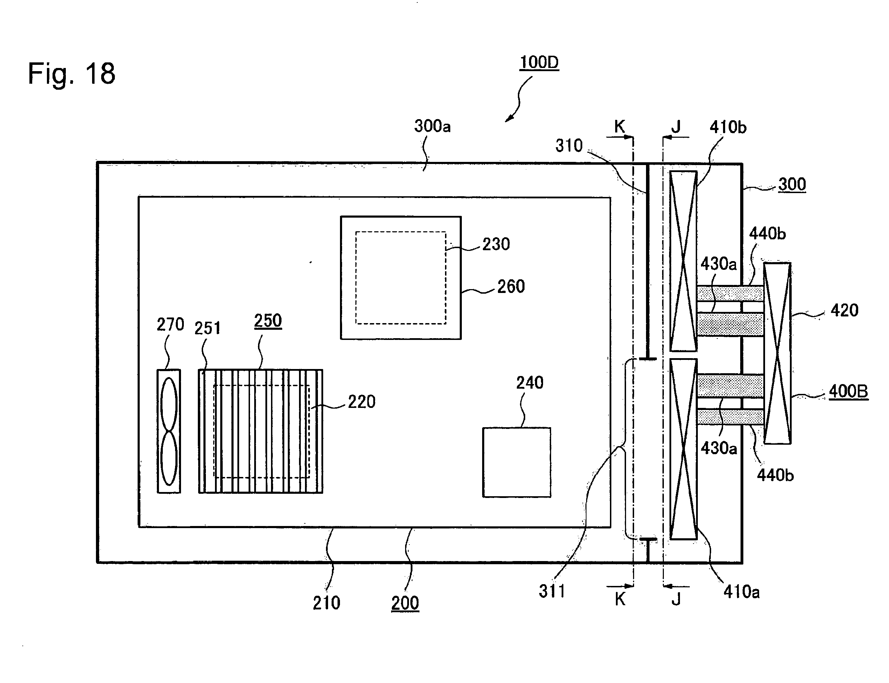

Fig. 18 is a surface perspective view showing a structure of the electronic substrate housing equipment 100D in the fourth exemplary embodiment of the present invention seen through from the upper surface side. Fig. 18 corresponds to Fig. 2. That is, Fig. 18 corresponds to a plan view seen from cutting plane A-A of Fig. 1, and indicates each structure when the top end part of the electronic substrate reception chamber 300a of the electronic substrate housing equipment 100D is cut horizontally.

Meanwhile, for convenience, the steam pipes 430a and 430b and the liquid pipes 440a and 440b are indicated parallely in Fig. 18 in spite of the positional relationships between them in the vertical direction. In reality, in the same positions in the vertical direction, the steam pipe 430a is arranged in a position higher than the liquid pipe 440a. Similarly, in the same positions in the vertical direction, the steam pipe 430b is arranged in a position higher than the liquid pipe 440b.

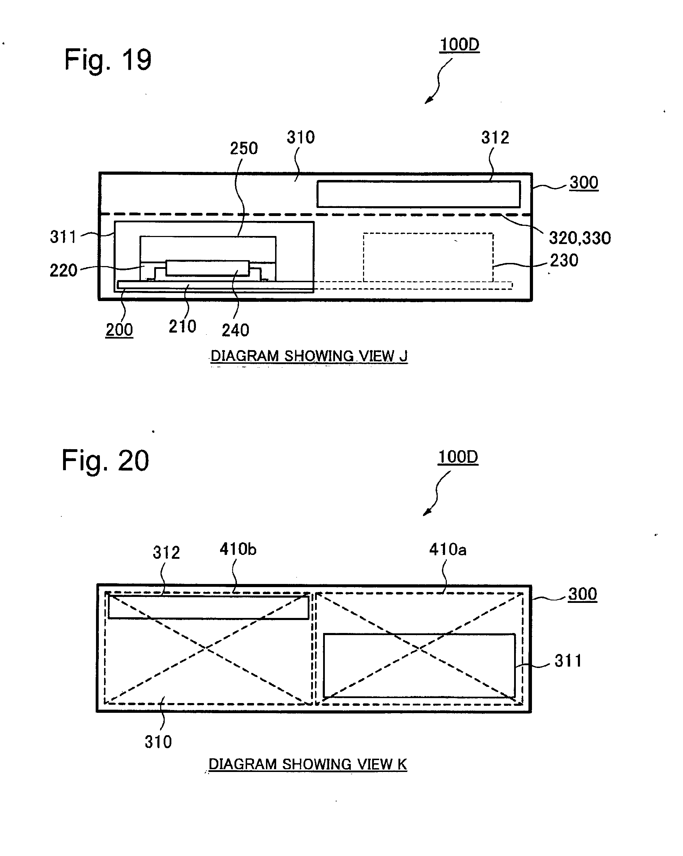

Fig. 19 is a diagram showing view J of Fig. 18. This Fig. 19 is identical with Fig. 3 substantially. Fig. 20 is a diagram showing view K of Fig. 18.

Meanwhile, in Figs. 18-20, a symbol equal to a symbol shown in Figs. 1-17 is attached to a component equal to each component shown in Figs. 1-17.

The electronic substrate housing equipment 100D can be installed in the rack 500 shown in Fig. 7 and Fig. 8. That is, the electronic apparatus 1000 is formed by installing the electronic substrate housing equipment 100D instead of the electronic substrate housing equipment 100 shown in Fig. 7 and Fig. 8.

As shown in Figs. 18-20, the electronic substrate housing equipment 100D is constituted including the electronic substrate 200, the chassis 300 and a cooling unit 400B.

Here, Figs. 2-4 and Figs. 18-20 are compared. In Figs. 2-4 and Figs. 18-20, the structures of the electronic substrate 200 and the chassis 300 are identical. On the other hand, as shown in Fig. 2 and Fig. 4, the cooling unit 400 has one piece of heat receiving part 410 and one piece of heat radiation part 420. In contrast, as shown in Fig. 18 and Fig. 20, the cooling unit 400B has two pieces of heat receiving parts 410a and 410b and one piece of heat radiation part 420. In accordance with this, two steam pipes and two liquid pipes are provided respectively as shown in 18 and Fig. 20.

That is, the cooling unit 400B is constituted including the first heat receiving part 410a, the second heat receiving part 410b, the heat radiation part 420, the steam pipes 430a and 430b, the liquid pipes 440a and 440b. Meanwhile, in the vertical direction, the steam pipe 430a is arranged in a position higher than the liquid pipe 440a. Similarly, in the vertical direction, the steam pipe 430b is arranged in a position higher than the liquid pipe 440b.

As shown in Fig. 18 and Fig. 20, the first heat receiving part 410a is provided in the heat receiving part reception chamber 300b such that it faces the warm air exhaust opening 311. And, the second heat receiving part 410b is also provided in the heat receiving part reception chamber 300b.

Here, in the cooling unit 400B, there are provided two circulating routes of refrigerant COO. That is, in a first circulating route, refrigerant COO circulates through the first heat receiving part 410a, the steam pipe 430a, the heat radiation part 420 and the liquid pipe 440a successively.

The first heat receiving part 410a receives heat from the electronic substrate 200 via blown air flowing in from the electronic substrate reception chamber 300a through the warm air exhaust opening 311. By forming this first circulating route, heat from the electronic substrate 200 which has been received by the first heat receiving part 410a is radiated.

In the second circulating route, refrigerant COO circulates through the second heat receiving part 410b, the steam pipe 430b, the heat radiation part 420 and the liquid pipe 440b successively. In the heat receiving part reception chamber 300b, the second heat receiving part 410b receives heat (heat from the electronic substrate 200) which the first heat receiving part 410a has not be able to receive. By forming this second circulating route, heat from the electronic substrate 200 which has been received by the second heat receiving part 410a is radiated.

As mentioned above, the electronic substrate housing equipment 100D in the fifth exemplary embodiment of the present invention includes the first heat receiving part 410a and the second heat receiving part 410b. The first heat receiving part 410a is provided in the heat part reception chamber 300b in a manner facing the warm air exhaust opening 311, and the second heat receiving part 410b is provided in the heat receiving part reception chamber 300b. As a result, the cooling unit 400B can radiate heat from the electronic substrate 200 more efficiently than the cooling unit 400 in the first exemplary embodiment.

### <Sixth exemplary embodiment>

A configuration of electronic substrate housing equipment 100E in the sixth exemplary embodiment of the present invention will be described based on a drawing.

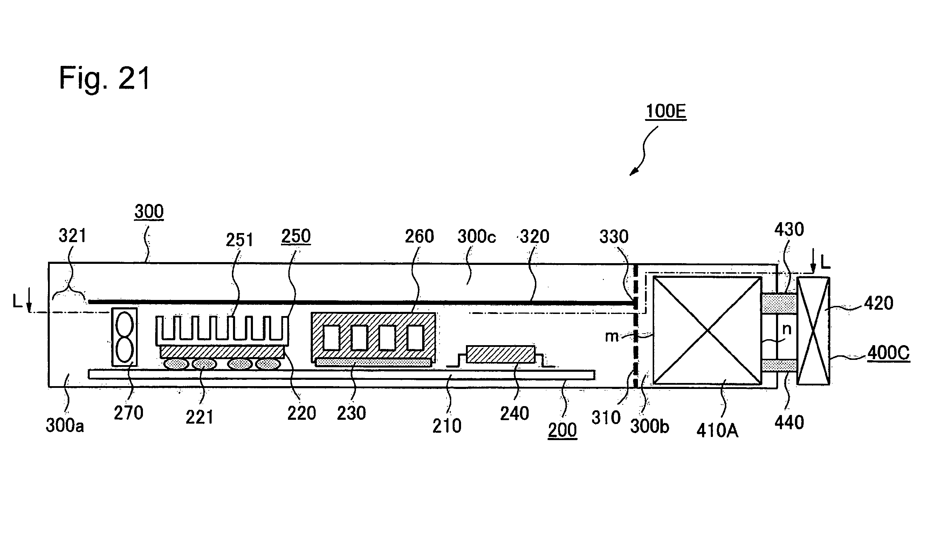

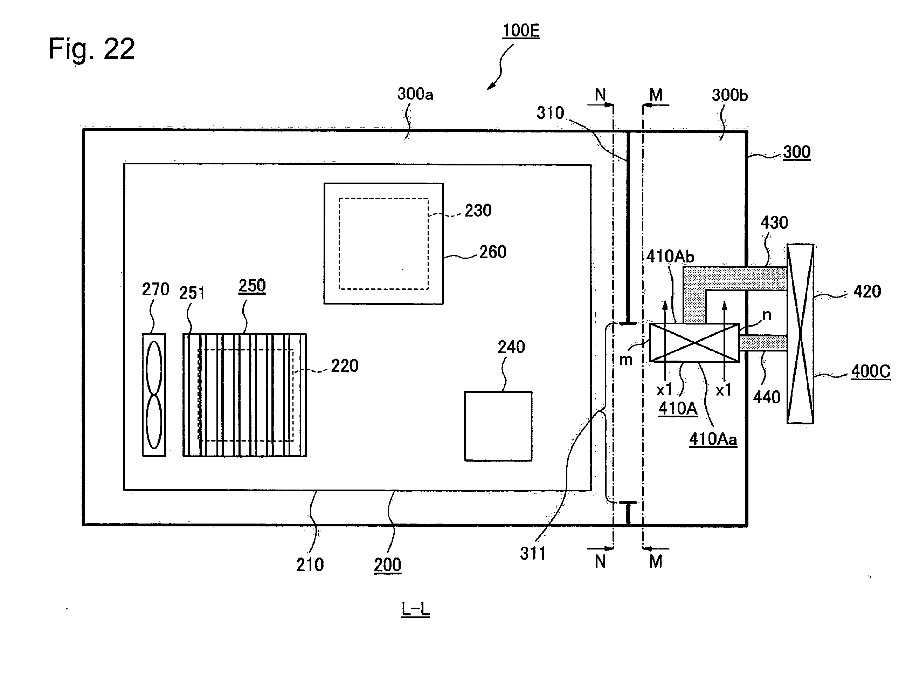

Fig. 21 is a side face perspective view showing a structure of the electronic substrate housing equipment 100E in the sixth exemplary embodiment of the present invention from a side. Fig. 22 is a surface perspective view seen from cutting plane L-L of Fig. 21. Meanwhile, in Fig. 22, for convenience, the steam pipe 430 and the liquid pipe 440 are being indicated as a parallely arranged state in spite of the positional relationship between them in the vertical direction. Actually, in the vertical direction, the steam pipe 430 is arranged in a position higher than the liquid pipe 440.

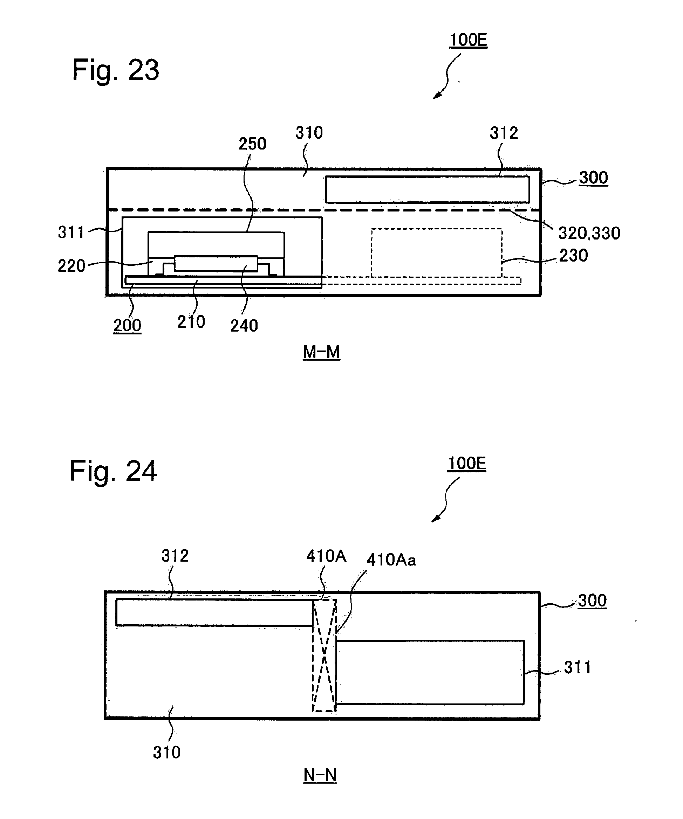

Fig. 23 is a side face perspective view seen from cutting plane M-M of Fig. 22. Fig. 23 is identical with Fig. 3 substantially. Fig. 24 is a side face perspective view seen from cutting plane N-N of Fig. 22.

Meanwhile, in Figs. 21-24, a symbol equal to a symbol shown in Figs. 1-20 is attached to a component equal to each component shown in Figs. 1-20.

The electronic substrate housing equipment 100E can be installed in the rack 500 shown in Fig. 7 and Fig. 8. That is, the electronic apparatus 1000 is formed by installing the electronic substrate housing equipment 100E instead of the electronic substrate housing equipment 100 shown in Fig. 7 and Fig. 8.

As shown in Figs. 21-24, the electronic substrate housing equipment 100E is constituted including the electronic substrate 200, the chassis 300 and a cooling unit 400C.

Here, Figs. 1-4 and Figs. 21-24 are compared. In Figs. 1-4 and Figs. 21-24, the structures of the electronic substrate 200 and the chassis 300 are identical.

On the other hand, as shown in Fig. 1, Fig. 2 and Fig. 4, the heat receiving part 410 of the cooling unit 400 is provided in a manner facing the warm air exhaust opening 311. In contrast, as shown in Fig. 21, Fig. 22 and Fig. 24, a heat receiving part 410A of the cooling unit 400C is not facing the warm air exhaust opening 311.

A configuration of the cooling unit 400C will be described in detail. As shown in Figs. 21-24, the cooling unit 400C is constituted including the heat receiving part 410A, the heat radiation part 420, the steam pipe 430 and the liquid pipe 440. Meanwhile, in the vertical direction, the steam pipe 430 is arranged in a position higher than the liquid pipe 440.

As shown in Fig. 21, Fig. 22 and Fig. 24, the heat receiving part 410A is formed into a rectangular flat plate shape. As shown in Fig. 22, the heat receiving part 410A is formed such that air can pass through it in the direction of arrow x1 along the thickness wise direction of the flat board. That is, the heat receiving part 410A has a structure through which air penetrates in a direction approximately perpendicular to a main surface 410Aa of the flat plane shape.

More specifically, similarly to the description using the above-mentioned Fig. 6, the heat-receiving-part fin part 414 of the heat receiving part 410A includes a plurality of fins, and is constituted so that air can pass between a plurality of fins. In other words, in the area of the heat-receiving-part fin part 414, air can go through between one face (the main surface 410Aa) and the other face (the face opposing the main surface 410Aa) of the heat receiving part 410A on a reciprocal basis.

Also, a direction approximately perpendicular to the main surface 410Aa of the flat plate shape of the heat receiving part 410A is not identical with the normal direction of the intake/exhaust air division plate 310. In this exemplary embodiment, the main surface 410Aa of the flat plate shape of the heat receiving part 410A does not face the face of the intake/exhaust air division plate 310.

In addition, one end m in a side part of the heat receiving part 410A of a flat plate shape is arranged near the warm air exhaust opening 311. On the other hand, other end n in a side part of the heat receiving part 410A of a flat plate shape is arranged in a manner being remote from the warm air exhaust opening 311.

Meanwhile, in Fig. 21, Fig. 22 and Fig. 24, there is indicated an example where a thickness wise direction of the heat receiving part 410A (the direction approximately perpendicular to the main surface 410Aa of the flat plate shape) is arranged in an approximately parallel direction to the face of the intake/exhaust air division plate 310.

Here, an effect obtained by setting a structure and arrangement of the heat receiving part 410A like the above in the electronic substrate housing equipment 100E will be described in detail using a drawing.

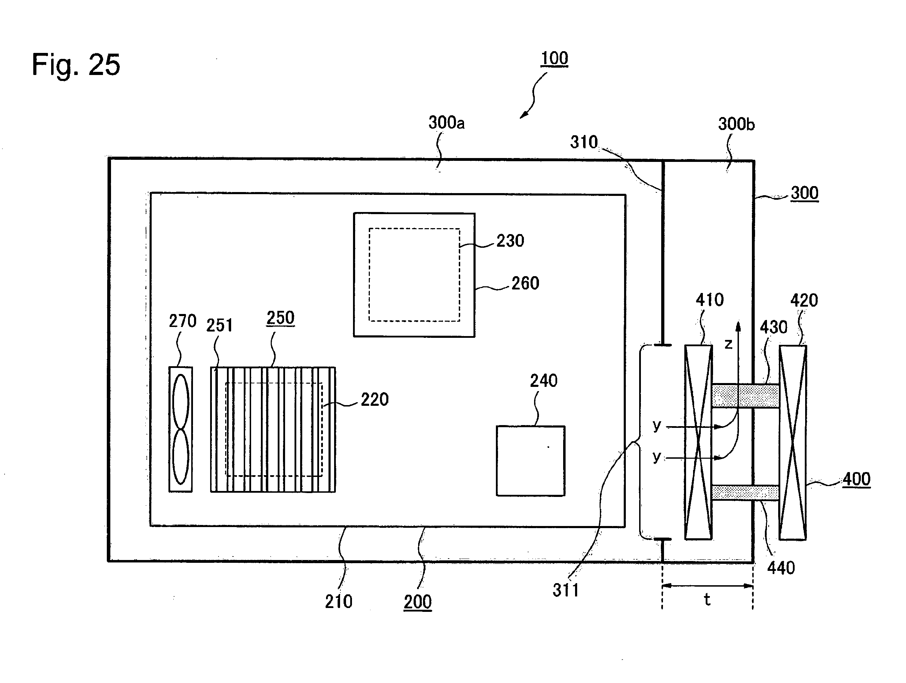

Fig. 25 is a diagram in which the structure of the electronic substrate housing equipment 100 in the first exemplary embodiment of the present invention is referred to and shown in order to explain the effect of the electronic substrate housing equipment 100E in the sixth exemplary embodiment of the present invention.

Meanwhile, Fig. 25 corresponds to Fig. 2. In Fig. 25, a symbol equal to a symbol shown in Figs. 1-24 is attached to a component equal to each component shown in Figs. 1-24.

In Fig. 25, it is assumed a case where, among the sizes of the heat receiving part reception chamber 300b, width t in an approximately perpendicular direction against the face of the intake/exhaust air division plate 310, for example, is small. Air including heat of the electronic substrate 200 flows into the heat receiving part reception chamber 300b through the warm air exhaust opening 311.

As indicated in arrow y, part of the air flowing into the heat receiving part reception chamber 300b flows in the direction of arrow z toward the cold air supply opening 312 side after passing through between the heat-receiving-part fin part 414 of the heat receiving part 410 and colliding with a wall of the chassis 300. Then, part of air flowing in the heat receiving part reception chamber 300b flows into the air guiding chamber 300c through the cold air supply opening 312.

However, when width t of the heat receiving part reception chamber 300b cannot be secured sufficiently relative to the thickness of the heat receiving part 410, air passing through the heat-receiving-part fin part 414 of the heat receiving part 410 in the direction of arrow y does not flow in the direction of arrow z unless it takes a turn at a steep angle.

Thus, when steep turning of an air flow is made, the flow velocity of the air declines because a flow path resistance becomes large. As a result, air does not circulate sufficiently between the electronic substrate receiving part 300a, the heat receiving part receiving part 300b and the air guiding chamber 300c, and thus capability to cool the heater element 220 becomes insufficient.

Accordingly, in the electronic substrate housing equipment 100E in the sixth exemplary embodiment of the present invention, it is arranged such that a direction approximately perpendicular to the main surface 410Aa of the flat plate shape of the heat receiving part 410A is not identical with the normal direction of the intake/exhaust air division plate 310.

Also, as mentioned above, in this exemplary embodiment, the main surface 410Aa of the flat plate shape of the heat receiving part 410A is set such that it does not face the intake/exhaust air division plate 310.

Further, one end m of a side part of the heat receiving part 410A of a flat plate shape is arranged near the warm air exhaust opening 311, and other end n in a side part of the heat receiving part 410A of the flat plate shape is arranged in a manner being remote from the warm air exhaust opening 311. In this case, air flowing in the heat receiving part reception chamber 300b via the warm air exhaust opening 311 passes through the heat receiving part 410A of a flat plate shape in the thickness wise direction.

Then, air which has passed through the heat receiving part 410A of a flat plate shape in a thickness wise direction flows into the cold air supply opening 312 side without causing steep-angled turning as described using Fig. 25. As a result, as shown in arrow x1 of Fig. 22, the flow of air which has passed through the heat receiving part 410A of a flat plate shape in a thickness wise direction can be led to the cold air supply opening 312 side smoothly.

Further, the thickness wise direction of the heat receiving part 410A may be arranged in an approximately parallel direction relative to the face of the intake/exhaust air division plate 310. Also in this case, a flow of air which has passed through the heat receiving part 410A of a flat plate shape in a thickness wise direction can be led to the cold air supply opening 312 side smoothly.

As above, in the electronic substrate housing equipment 100E and 100F in the sixth exemplary embodiment of the present invention, the heat receiving part 410A is formed into a flat plate shape. The heat receiving part 410A has a structure through which air penetrates through in a direction approximately perpendicular to the main surface 410Aa of the flat plate shape. And, the heat receiving part 410A is arranged in a position where a direction approximately perpendicular to the main surface 410Aa of the flat plate shape of the heat receiving part 410A is not identical with the normal direction of the intake/exhaust air division plate 310. Furthermore, one end m of a side part of the heat receiving part 410A of a flat plate shape is arranged near the warm air exhaust opening 311, and other end n in a side part of the heat receiving part 410A of the flat plate shape is arranged in a manner far from the warm air exhaust opening 311.

As a result, even when width t of an approximately perpendicular direction against the face of the intake/exhaust air division plate 310 among the sizes of the heat receiving part reception chamber 300b is small, for example, a flow of air which has passed through the heat receiving part 410A in a thickness wise direction (the direction approximately perpendicular to the main surface 410Aa of the flat plate shape) of the heat receiving part 410A can be led to the cold air supply opening 312 side smoothly.

Accordingly, air flowing in the heat receiving part reception chamber 300b through the warm air exhaust opening 311 can be led to the cold air supply opening 312 side smoothly after having made it pass through the heat receiving part 410B of a flat plate shape.

As a result, air can be made to circulate through between the electronic substrate receiving part 300a, the heat receiving part receiving part 300b and the air guiding chamber 300c sufficiently, and thus heat of the electronic substrate 200 can be radiated more efficiently.

### <Seventh exemplary embodiment>

A configuration of electronic substrate housing equipment 100F in the seventh exemplary embodiment of the present invention will be described based on a drawing.

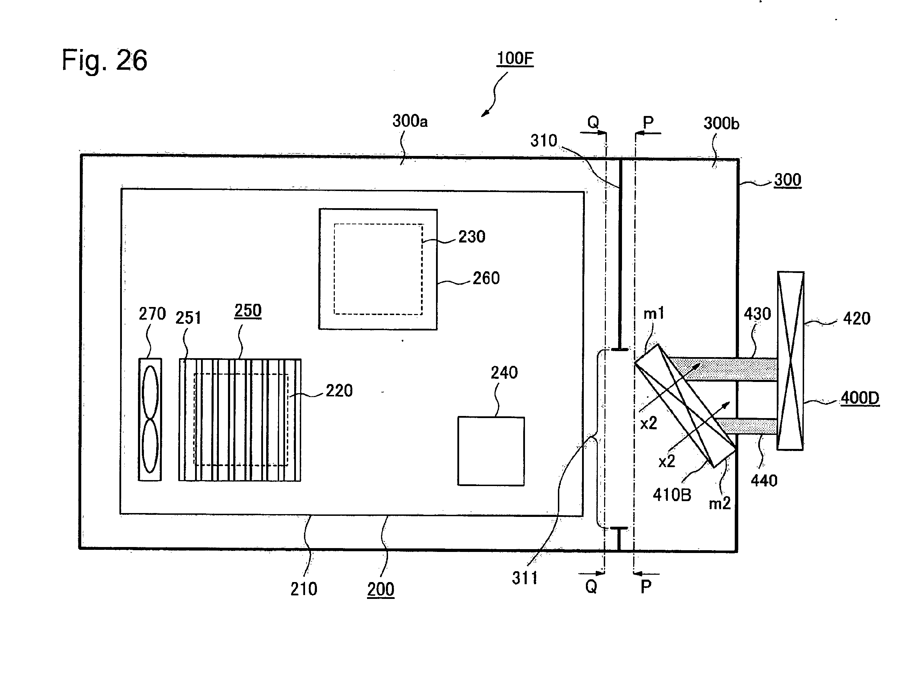

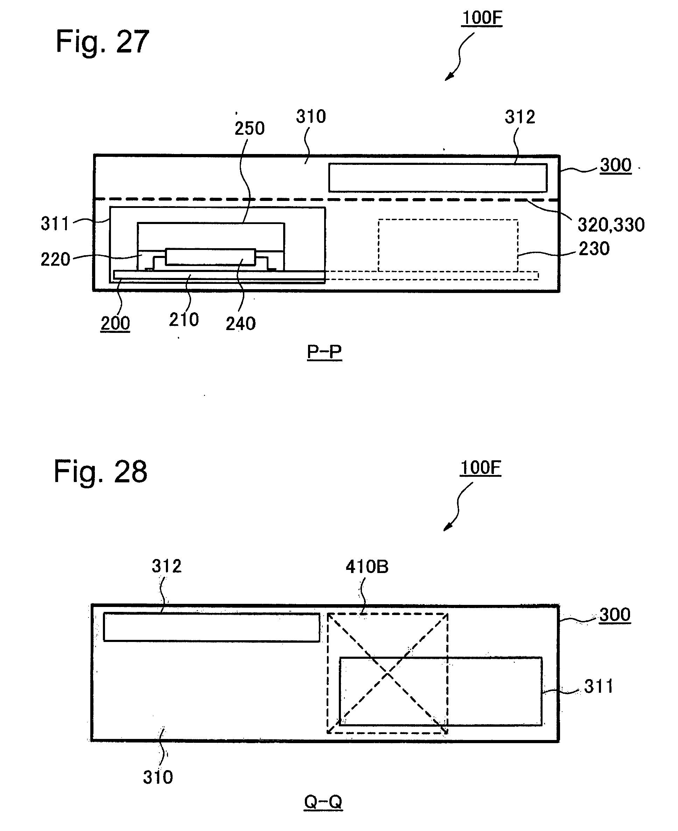

Fig. 26 is a surface perspective view showing a structure of the electronic substrate housing equipment 100F in the seventh exemplary embodiment of the present invention seen through from the upper surface side. Meanwhile, this Fig. 26 is a diagram corresponding to Fig. 22. That is, Fig. 26 corresponds to Fig. 22, and indicates each structure when the top end part of the electronic substrate reception chamber 300a of electronic substrate housing equipment 100F is cut horizontally. Fig. 27 is a side face perspective view seen from cutting plane P-P of Fig. 26. Fig. 27 is identical with Fig. 3 substantially. Fig. 28 is a side face perspective view seen from cutting plane Q-Q of Fig. 26.

Meanwhile, in Figs. 26-28, a symbol equal to a symbol shown in Figs. 1-25 is attached to a component equal to each component shown in Figs. 1-25.

The electronic substrate housing equipment 100F can be installed in the rack 500 shown in Fig. 7 and Fig. 8. That is, the electronic apparatus 1000 is formed by installing the electronic substrate housing equipment 100F instead of the electronic substrate housing equipment 100 shown in Fig. 7 and Fig. 8.

As shown in Figs. 26-28, the electronic substrate housing equipment 100F is constituted including the electronic substrate 200, the chassis 300 and a cooling unit 400D. The cooling unit 400D is constituted including a heat receiving part 410B, the heat radiation part 420, the steam pipe 430 and the liquid pipe 440.

Here, Figs. 21-24 and Figs. 26-28 are compared. In Figs. 21-24 and Figs. 26-28, the structures of the electronic substrate 200 and the chassis 300 are identical. On the other hand, in the cooling unit 400B and 400C, they differ from each other.

As shown in Fig. 21, Fig. 22 and Fig. 24, in the heat receiving part 410A of the cooling unit 400C, a thickness wise direction (the direction approximately perpendicular to the main surface 410Aa of the flat plate shape) of the heat receiving part 410A is arranged in an approximately parallel direction to the face of the intake/exhaust air division plate 310. In contrast, as shown in Fig. 26 and Fig. 28, in the heat receiving part 410B of the cooling unit 400D, the thickness wise direction of the heat receiving part 410B is not arranged in an approximately parallel direction to the face of the intake/exhaust air division plate 310.

As shown in Fig. 21, Fig. 22 and Fig. 24, in the cooling unit 400C, the heat receiving part 410A does not face the warm air exhaust opening 311. In contrast, as shown in Fig. 26 and Fig. 28, in the cooling unit 400D, part of the heat receiving part 410B faces the warm air exhaust opening 311.

Even in such structure, the heat receiving part 410A is arranged in a position where a direction approximately perpendicular to the main surface 410Aa of the flat plate shape of the heat receiving part 410A is not identical with the normal direction of the intake/exhaust air division plate 310. One end m1 in a side part of the heat receiving part 410B of a flat plate shape is arranged near the warm air exhaust opening 311, and other end m2 in a side part of the heat receiving part 410B of a flat plate shape is arranged in a manner being far from the warm air exhaust opening 311.

In this case, air flowing in the heat receiving part reception chamber 300b through the warm air exhaust opening 311 goes through the heat receiving part 410B of a flat plate shape in a thickness wise direction as indicated by arrow x2 of Fig. 26.

Then, after hitting a wall of a chassis 300b, air which has gone through the heat receiving part 410A of the flat plate shape in a thickness wise direction flows to the cold air supply opening 312 side without causing steep-angled turning described using Fig. 25.

Accordingly, air flowing in the heat receiving part reception chamber 300b through the warm air exhaust opening 311 can be led to the cold air supply opening 312 side smoothly after having made it pass through the heat receiving part 410B of a flat plate shape. As above, also in the electronic substrate housing equipment 100F in the seventh exemplary embodiment of the present invention, the same effect as the electronic substrate housing equipment 100E in the sixth exemplary embodiment of the present invention can be made.

### <Eighth exemplary embodiment>

A configuration of electronic substrate housing equipment 100G in the eighth exemplary embodiment of the present invention will be described based on a drawing.

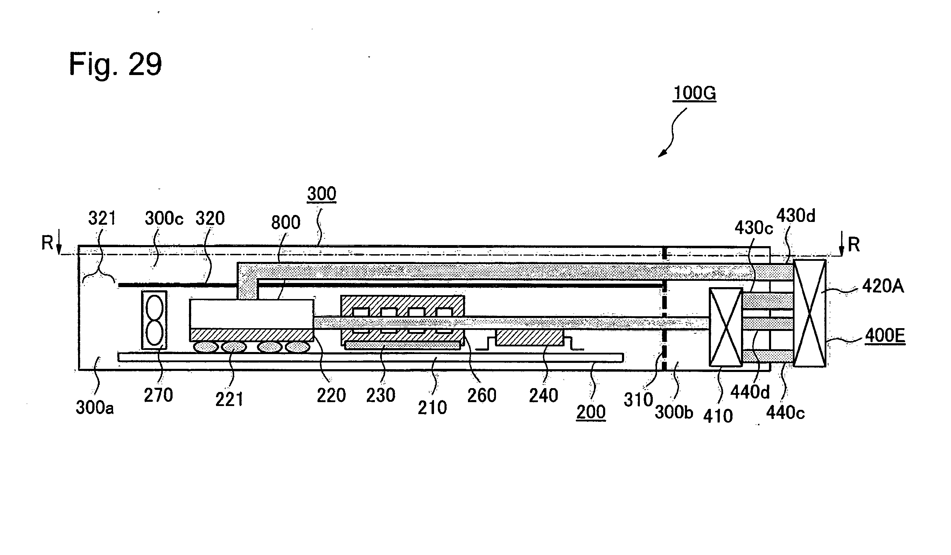

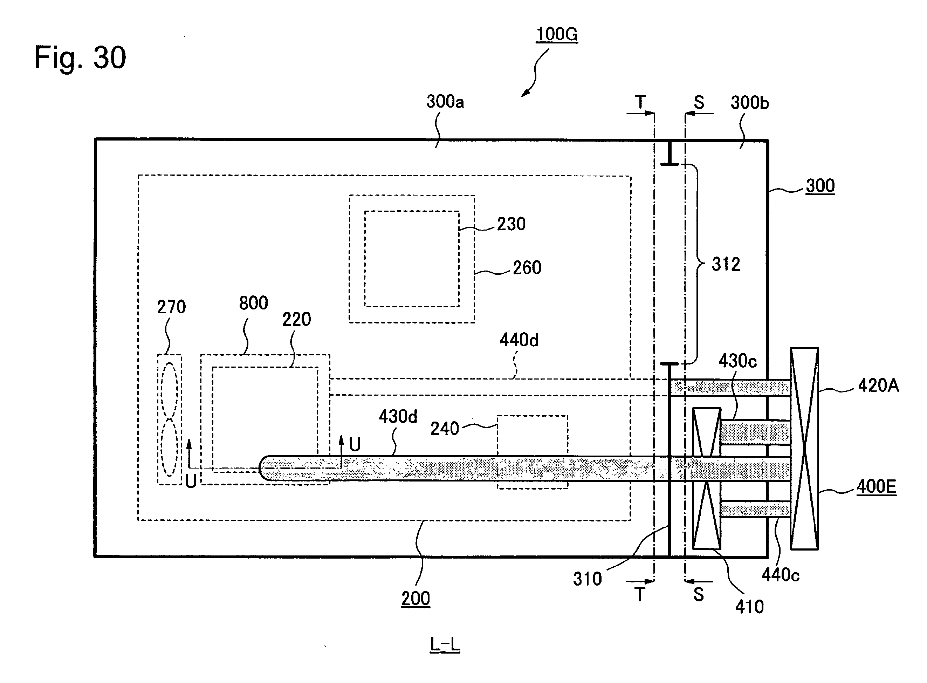

Fig. 29 is a side face perspective view showing a structure of the electronic substrate housing equipment 100G in the eighth exemplary embodiment of the present invention seen through from a side. Fig. 30 is a surface perspective view seen from cutting plane R-R of Fig. 29.

Meanwhile, in Fig. 30, for convenience, there is indicated an arrangement that is seen through in spite of the positional relationships between the steam pipes 430c and 430d and the liquid pipes 440c and 440d in the vertical direction. In reality, in the vertical direction, the steam pipe 430c is arranged in a position higher than the liquid pipe 440c. Similarly, in the vertical direction, the steam pipe 430d is arranged in a position higher than the liquid pipe 440d.

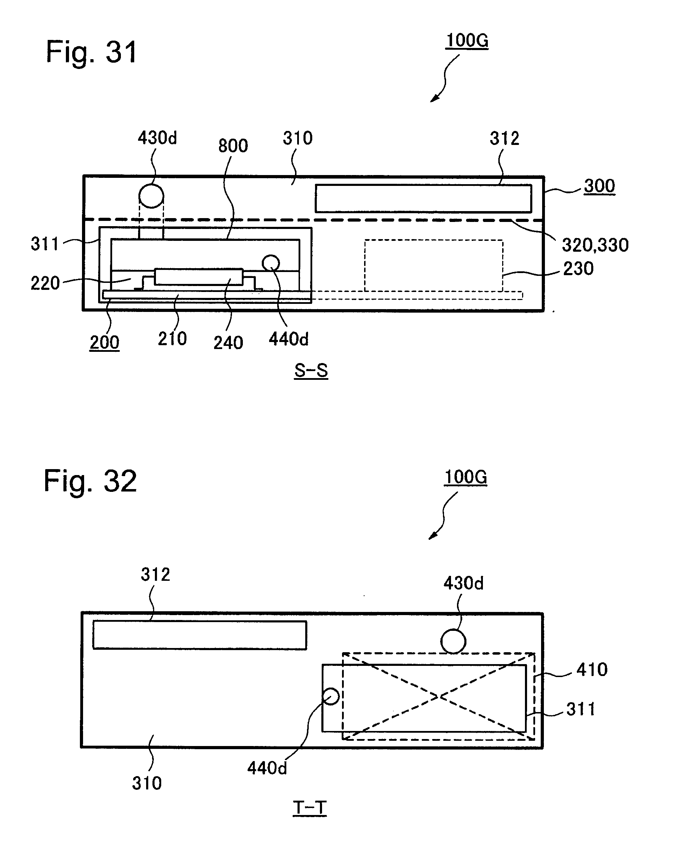

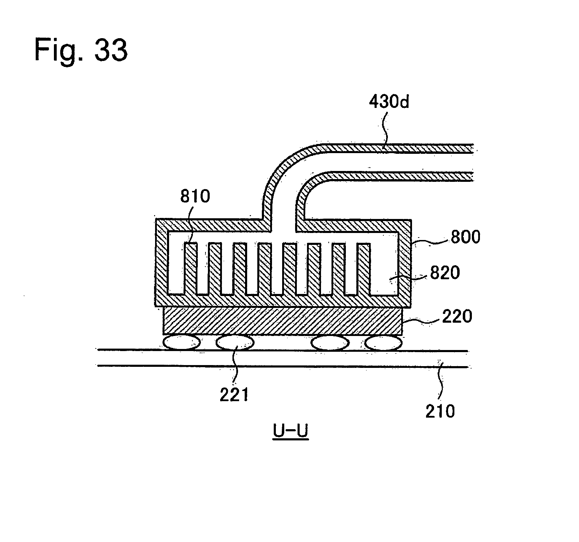

Fig. 31 is a side face perspective view seen from cutting plane S-S of Fig. 30. Fig. 32 is a side face perspective view seen from cutting plane T-T of Fig. 30. Fig. 33 is a sectional view showing a section when being cut by cutting plane U-U of Fig. 30.

Meanwhile, in Figs. 29-33, a symbol equal to a symbol shown in Figs. 1-28 is attached to a component equal to each component shown in Figs. 1-28.

The electronic substrate housing equipment 100G can be installed in the rack 500 shown in Fig. 7 and Fig. 8. That is, the electronic apparatus 1000 is formed by installing the electronic substrate housing equipment 100G instead of the electronic substrate housing equipment 100 shown in Fig. 7 and Fig. 8.

As shown in Figs. 29-33, the electronic substrate housing equipment 100G is constituted including the electronic substrate 200, the chassis 300 and a cooling unit 400E.

The cooling unit 400E is constituted including the heat receiving part 410, a heater-element heat receiving part 800, the steam pipes 430c, 430d, the liquid pipes 440c and 440d.

Here, Figs. 1-4 and Figs. 29-33 are compared. In Figs. 1-4 and Figs. 19-33, the basic structures of the electronic substrate 200 and the chassis 300 are identical.

On the other hand, as shown in Fig. 1 and Fig. 2, the cooling unit 400 has one piece of heat receiving part 410 and one piece of heat radiation part 420 respectively. In contrast, as shown in Fig. 29, Fig. 30 and Fig. 33, the cooling unit 400E has two heat receiving parts (the heat receiving part 410 and the heater-element boiling heat receiving part 800) and one piece of heat radiation part 420A.

In accordance with this, there are provided two steam pipes 430c and 430d and two liquid pipes 440c and 440d respectively as shown in Fig. 29 and Fig. 30.

As shown in Fig. 1 and Fig. 2, the heater-element heat receiving part 250 is mounted independently on the heater element 220. In contrast, as shown in Fig. 29 and Fig. 30, the heater-element boiling heat receiving part 800 is connected by the steam pipe 430d and the liquid pipe 440d to the heat radiation part 420A, and configures part of the cooling unit 400E.

That is, the cooling unit 400E is constituted including the heat receiving part 410, the heater-element boiling heat receiving part 800, the heat radiation part 420A, the steam pipes 430c and 430d, the liquid pipes 440c and 440d. The heater-element boiling heat receiving part 800 corresponds to an element heat receiving part of the present invention.

Meanwhile, in the vertical direction, the steam pipe 430c is arranged in a position higher than the liquid pipe 440c. Similarly, in the vertical direction, the steam pipe 430d is arranged in a position higher than the liquid pipe 440d.

The heater-element boiling heat receiving part 800 is attached on the heater element 220 in a state that it is connected thermally with the heater element 220 using thermally conductive grease or the like. Meanwhile, the heater-element boiling heat receiving part 800 is formed of a thermal conductivity member such as aluminum, copper and alloys of them, and, more preferably, by a material having a small thermal resistance.

The heater-element boiling heat receiving part 800 stores refrigerant COO. That is, refrigerant COO is sealed in a closed space including the heat receiving part 410, the heat radiation part 420A, the steam pipes 430c and 430d, the liquid pipes 440c and 440d and the heater-element boiling heat receiving part 800.

In the heater-element boiling heat receiving part 800, refrigerant COO is boiled and vaporized by heat of the heater element 220.

As shown in Fig. 33, a plurality of pieces of tabular heater elements boiling heat receiving part side fin part 810 are provided in a refrigerant boiling part 820 of the heater-element boiling heat receiving part 800.

By enlarging a radiating area of heat from the heater element 220, the heater element boiling heat receiving part side fin part 810 transfers heat to refrigerant COO more efficiently.

Meanwhile, here, it has been explained that the shape of the heater element boiling heat receiving part side fin part 810 is made to be of a tabular shape. However, the heater element boiling heat receiving part side fin part 810 should have just a wide surface area in order to fulfil a function to spread heat, and thus it may be formed into a pinholder shape, a stick shape and a bellows shape, for example.

Also, although it has been explained that a plurality of pieces of tabular heater element boiling heat receiving part side fin part 810 are provided in the refrigerant boiling part 820, it is not limited to this and a plurality of pieces of tabular heater element boiling heat receiving part side fin part 810 are not have to be provided.

Here, as shown in Fig. 29 and Fig. 30, the heat receiving part 410 and the heat radiation part 420A are connected by the steam pipe 430c and the liquid pipe 440c. Also, the heater-element boiling heat receiving part 800 and the heat radiation part 420A are connected by the steam pipe 430d and the liquid pipe 440d.

As shown in Fig. 32, the heat receiving part 410 is provided such that it faces the warm air exhaust opening 311.

As shown in Fig. 29 and Fig. 30, in the cooling unit 400E, two circulating routes of refrigerant COO are provided.

That is, in a first circulating route, refrigerant COO circulates through the heat receiving part 410, the steam pipe 430c, the heat radiation part 420A and the liquid pipe 440c, successively. The heat receiving part 410 receives heat of the electronic substrate 200 via blown air flowing in from the electronic substrate reception chamber 300a through the warm air exhaust opening 311. By forming this first circulating route, heat of the electronic substrate 200 which has been received by the heat receiving part 410 via blown air is radiated.

Further, in a second circulating route, refrigerant COO circulates through the heater-element boiling heat receiving part 800, the steam pipe 430d, the heat radiation part 420A and the liquid pipe 440d, successively. The heater-element boiling heat receiving part 800 receives heat of the heater element 220 on the electronic substrate 200 directly.

Heat of the heater element 220 which has been received by the heater-element boiling heat receiving part 800 vaporizes refrigerant COO stored in the refrigerant boiling part 820. Then, the vaporized refrigerant COO flows into the heat radiation part 420A.

Next, in the heat radiation part 420A, refrigerant COO is cooled, and condensed to liquid. As a result, heat of the heater element 220 is radiated. Refrigerant COO cooled by heat radiation by the heat radiation part 420A will be in the liquid phase state, and again, flow into the heater-element boiling heat receiving part 800.

By forming this second circulating route, heat of the electronic substrate 200 (in particular, of the heater element 220) which has been received by the heater-element boiling heat receiving part 800 is radiated.

As mentioned above, the electronic substrate housing equipment 100G in the eighth exemplary embodiment of the present invention includes the heater-element boiling heat receiving part 800 and a pipe (the steam pipe 430c). The heater-element boiling heat receiving part 800 is provided on the heater element 220, and receives heat of the heater element 220 directly. The pipe (the steam pipe 430c) connects between the heater-element boiling heat receiving part 800 and the heat radiation part 420A. As a result, by the heat radiation part 420A, heat of the heater element 220 can be radiated using refrigerant COO as a medium. As a result, in the electronic substrate housing equipment 100G, heat of the electronic substrate 200 can be radiated more efficiently.

### <Ninth exemplary embodiment>

A configuration of electronic substrate housing equipment 100H in the ninth exemplary embodiment of the present invention will be described based on a drawing.

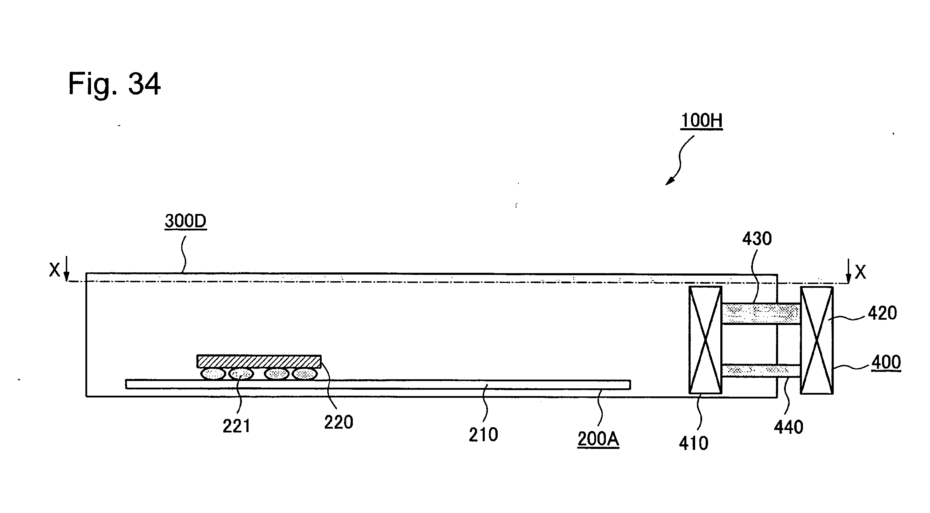

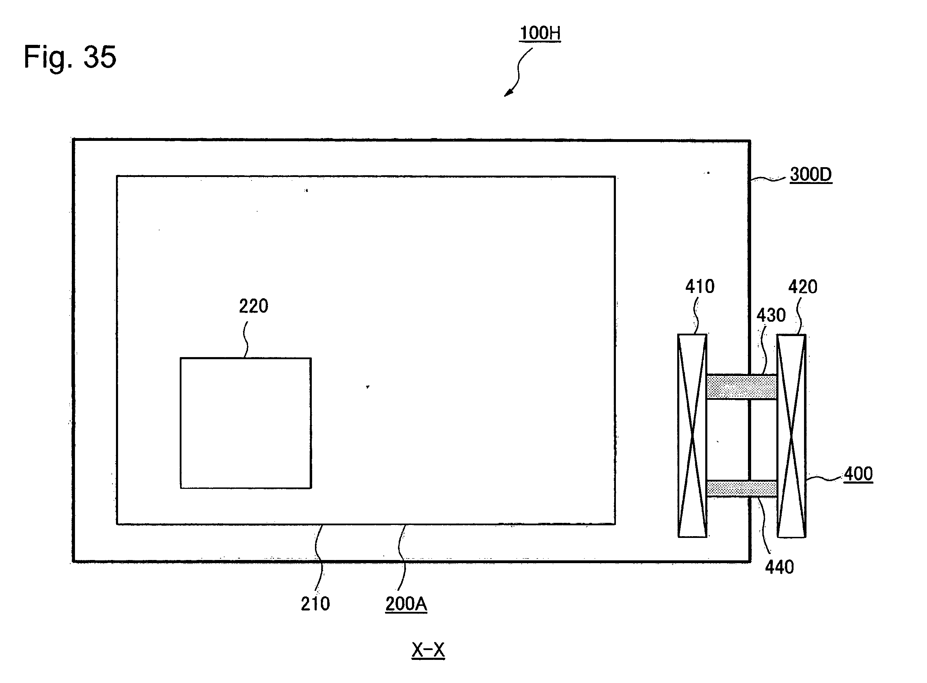

Fig. 34 is a side face perspective view showing a structure of the electronic substrate housing equipment 100H in the ninth exemplary embodiment of the present invention seen through from a side. Fig. 35 is a surface perspective view seen from cutting plane X-X of Fig. 34. Meanwhile, in Fig. 35, for convenience, a planar arrangement state is indicated in spite of the positional relationship between the steam pipe 430 and the liquid pipe 440 in the vertical direction. In reality, in the vertical direction, the steam pipe 430 is arranged in a position higher than the liquid pipe 440.

Meanwhile, in Fig. 34 and Fig. 35, a symbol equal to a symbol shown in Figs. 1-33 is attached to a component equal to each component shown in Figs. 1-33.

The electronic substrate housing equipment 100H can be installed in the rack 500 shown in Fig. 7 and Fig. 8. That is, the electronic apparatus 1000 is formed by installing the electronic substrate housing equipment 100H instead of the electronic substrate housing equipment 100 shown in Fig. 7 and Fig. 8.

As shown in Fig. 34 and Fig. 35, the electronic substrate housing equipment 100H is constituted including an electronic substrate 200A, a chassis 300D and the cooling unit 400.

Here, Fig. 1, Fig. 2, Fig. 34 and Fig. 35 are compared. In Fig. 1, Fig. 2, Fig. 34 and Fig. 35, although the structure of the cooling unit 400 is identical, the structures of the electronic substrates 200 and 200A and the chassis 300 and 300D differ respectively. That is, as shown in Fig. 1 and Fig. 2, the electronic substrate 200 is equipped with the electronic component 230 and the like on the substrate material 210 besides the heater element 220.

In contrast, as shown in Fig. 34 and Fig. 35, the electronic substrate 200A is equipped with at least the heater element 220 on the substrate material 210.

Meanwhile, the heater element 220 is attached to the substrate material 210 via such as the solder 221. In Fig. 34 and Fig. 35, the chassis 300D includes only one room unlike Fig. 1 and Fig. 2.

The structure and operations of the cooling unit 400 are the same as those having been described in the first exemplary embodiment.

As above, the electronic substrate housing equipment 100H in the ninth exemplary embodiment of the present invention has the electronic substrate 200A, the chassis 300D and the cooling unit 400. The electronic substrate 200A mounts the heater element 220. The chassis 300D houses the electronic substrate 200 in an airtight manner. The cooling unit 400 cools the electronic substrate 200. The cooling unit 400 includes the heat receiving part 410 and the heat radiation part 420. The heat receiving part 410 receives heat from the electronic substrate 200. The heat radiation part 420 is connected with the heat receiving part 410, and radiates heat from the electronic substrate 200 which has been received by the heat receiving part 410. The heat receiving part 410 is provided in the chassis 300D in an airtight manner and the heat radiation part 420 is provided outside the chassis 300.

Thus, the heat receiving part 410 receives heat from the electronic substrate 200A in the sealed chassis 300D. Then, heat from the electronic substrate 200A which has been received by the heat receiving part 410 is radiated by the heat radiation part 420. At that time, because the heat radiation part 420 is provided outside the chassis 300D, it is possible to radiate heat from the electronic substrate 200 outside the chassis 300D.

Accordingly, in the electronic substrate housing equipment 100H, it is possible to radiate heat from the electronic substrate 200A sealed in the chassis 300A outside the chassis 300D. As a result, because, in the electronic substrate housing equipment 100H, exhaust heat from the electronic substrate 200A does not fill the chassis 300D while still keeping a state that the electronic substrate 200A is made to be sealed in the chassis 300D, heat of the electronic substrate 200A can be cooled efficiently.

In addition, because the electronic substrate 200A is housed in the chassis 300D in an airtight manner, even when electronic substrate housing equipment is replaced at the time of maintenance operations and at the time of replacement work, for example, it is possible to prevent trash and dust from entering the chassis 200A from outside the chassis 300D.

Thus, according to the electronic substrate housing equipment 100H in the ninth exemplary embodiment of the present invention, efficient cooling is possible, and moreover, maintenance replacement work can be performed for each electronic substrate housing equipment 100H individually.

As above, the present invention has been described based on the exemplary embodiments. An exemplary embodiment is just an illustration, and various kinds of changes, addition or subtraction and combinations may be added to each of the above-mentioned exemplary embodiments unless it deviates from the main points of the present invention. It is understood by a person skilled in the art that modification made by adding such changes, addition/subtraction and combinations are also included in the scope of the present invention

This application claims priority based on Japanese application Japanese Patent Application No. 2011-263753, filed on December 1, 2011, the disclosure of which is incorporated herein in its entirety.

### Industrial Applicability

Electronic substrate housing equipment and an electronic substrate of the present invention can be applied to electronic substrate housing equipment and an electronic substrate having a structure to radiate heat of the electronic substrate onto which a heater element is mounted, for example.

### Description of Symbols

- 100: Electronic substrate housing equipment
- 100A, 100B, 100C, 100D and 100E: Electronic substrate housing equipment
- 100F, 100G and 100H: Electronic substrate housing equipment
- 200 and 200A: Electronic substrate
- 210: Substrate material
- 220: Heater element
- 230 and 240: Electronic component
- 250: Heater-element heat receiving part
- 251: Heater-element-heat-receiving-part-side fin
- 260: Electronic-component heat receiving part
- 270: Electronic-substrate fan
- 300 and 300D: Chassis
- 300A: First chassis
- 300B and 300C: Second chassis
- 300a: Electronic substrate reception chamber
- 300b: Heat receiving part reception chamber
- 300c: Air guiding chamber
- 310 and 310A: Intake/exhaust air division plate
- 311: Warm air exhaust opening
- 312: Cold air supply opening
- 320: Partition plate
- 321: Communication hole
- 330, 330a, 330b, 340a and 340b: Joint
- 400, 400A, 400B, 400C, 400D and 400E: Cooling unit
- 410, 410A and 410B: Heat receiving part
- 410a: First heat receiving part
- 410b: Second heat receiving part
- 411: Upper tank part
- 412: Lower tank part
- 413: Connecting pipe part
- 414: Heat-receiving-part fin part
- 420 and 420A: Heat radiation part
- 421: Upper tank part
- 422: Lower tank part
- 423: Connecting pipe part
- 424: Heat-radiation-part fin part
- 430, 430a, 430b, 430c and 430d: Steam pipe
- 440, 440a, 440b, 440c and 440d: Liquid pipe
- 450: Pump part
- 500: Rack
- 510: Air intake vent
- 520: Exhaust vent
- 530: Rack fan part
- 600: First electronic equipment
- 700 and 700A: Second electronic equipment
- 800: Heater-element boiling heat receiving part
- 810: Heater element boiling heat receiving part side fin part
- 820: Refrigerant boiling part
- 1000, 1000A and 1000B: Electronic apparatus

## Claims

1. Electronic substrate housing equipment, comprising:
an electronic substrate to mount a heater element;
a chassis to house said electronic substrate in an airtight manner;
a cooling unit to cool said electronic substrate; and
said cooling unit including:
a heat receiving part to receive heat from said electronic substrate;
a heat radiation part, connected with said heat receiving part, to radiate heat received by said heat receiving part; and
said heat receiving part being provided in said chassis in an airtight manner, and said heat radiation part being provided outside said chassis.

2. The electronic substrate housing equipment according to claim 1, wherein
said chassis comprises:
an electronic substrate reception chamber to house said electronic substrate;
a heat receiving part reception chamber to house said heat receiving part;
an air guiding chamber to form a flow path of air between said heat receiving part reception chamber and said electronic substrate reception chamber;
a division plate provided between said heat receiving part reception chamber and each of said heat receiving part reception chamber and said air guiding chamber;
a partition plate provided between said air guiding chamber and said electronic substrate reception chamber;
a first opening, formed in said division plate, to link between said electronic substrate reception chamber and said heat receiving part reception chamber;
a second opening, formed in said division plate, to link between said heat receiving part reception chamber and said air guiding chamber; and
a third opening, formed in said partition plate, to link said air guiding chamber and said electronic substrate reception chamber, and wherein
a flow path of air circulating through between said electronic substrate reception chamber, said heat receiving part reception chamber and said air guiding chamber via said first opening, said second opening and said third opening is formed.

3. The electronic substrate housing equipment according to claim 2, wherein
said heat receiving part includes a first heat receiving part provided in a manner facing said first opening.

4. The electronic substrate housing equipment according to claim 3, wherein
said heat receiving part includes a second heat receiving part provided in said heat receiving part reception chamber in addition to said first heat receiving part.

5. The electronic substrate housing equipment according to claim 2, wherein
said heat receiving part is of a flat plate shape and of a structure to allow air to penetrate through in a direction perpendicular to a main surface of said flat plate shape, and is arranged in a position to make a direction perpendicular to said main surface of said heat receiving part be not identical with a normal direction of said division plate; and wherein
one end in a side part of said flat plate shape of said heat receiving part is arranged near said first opening, and an other end in a side part of said flat plate shape of said heat receiving part is arranged as being far from said first opening.

6. The electronic substrate housing equipment according to any one of claims 2-5, comprising:
first electronic equipment being constituted including said electronic substrate reception chamber and said air guiding chamber: a second electronic equipment being constituted including said heat receiving part reception chamber; and a joint connecting said first electronic equipment and said second electronic equipment.

7. The electronic substrate housing equipment according to claim 6, wherein
said second electronic equipment is constituted in a manner allowing a plurality of pieces of said first electronic equipment to be connected.

8. The electronic substrate housing equipment according to any one of claims 1-7, further comprising:
an element heat receiving part, provided on said heater element, to store a refrigerant; and
a pipe to connect between said element heat receiving part and said heat radiation part.

9. The electronic substrate housing equipment according to claim 2, wherein
said division plate includes:
a first division plate provided between said electronic substrate reception chamber and said heat receiving part reception chamber; and
a second division plate provided between said heat receiving part reception chamber and said air guiding chamber, wherein
said first opening is formed in said first division plate; and wherein
said second opening is formed in said second division plate.

10. The electronic substrate housing equipment according to any one of claims 2-9, comprising:
a fan part provided in said electronic substrate reception chamber, wherein
said fan part is provided in a manner making said heater element be arranged between said fan part and said first opening, and wherein
air in said chassis is boosted to circulate between said electronic substrate reception chamber, said heat receiving part reception chamber and said air guiding chamber.

11. The electronic substrate housing equipment according to any one of claims 1-10, wherein
said cooling unit stores a refrigerant circulating through between said heat receiving part and said heat radiation part internally, wherein
said heat receiving part receives heat from said electronic substrate, and transfers received heat to said refrigerant, and wherein
said heat radiation part makes said refrigerant flowing in from said heat receiving part be condensed.

12. The electronic substrate housing equipment according to claim 11, further comprising:
a pump to promote circulation of said refrigerant arranged between said heat receiving part and said heat radiation part.

13. Electronic apparatus, comprising:
electronic substrate housing equipment and a rack to house said electronic substrate housing equipment, wherein
said electronic substrate housing equipment includes:
an electronic substrate to mount a heater element;
a chassis to house said electronic substrate in an airtight manner; and
a cooling unit, wherein
said cooling unit includes:
a heat receiving part to receive heat from said electronic substrate; and
a heat radiation part, connected with said heat receiving part, to radiate heat received by said heat receiving part; and wherein
said heat receiving part is provided in said chassis in an airtight manner, and said heat radiation part is provided outside said chassis.
